# EUROPEAN PATENT SPECIFICATION

(11) **EP 2 434 543 B1**
(45) Date of publication and mention of the grant of the patent: **09.04.2014**
(21) Application number: 09844894.7
(22) Date of filing: 19.05.2009
(51) Int. Cl.: H01L 23/473, B21J 5/06, G12B 15/06, H05K 7/20

(54) **HEAT EXCHANGER AND METHOD OF MANUFACTURING THE SAME**
WÄRMETAUSCHER UND VERFAHREN ZU SEINER HERSTELLUNG
ECHANGEUR THERMIQUE ET SON PROCÉDÉ DE FABRICATION

(43) Date of publication of application: 28.03.2012
(73) Proprietor: TOYOTA JIDOSHA KABUSHIKI KAISHA, Toyota-shi, Aichi-ken, 471-8571 (JP)
(72) Inventor: MORINO Masahiro, Toyota-shi, Aichi-ken 471-8571 (JP); TAKETSUNA Yasuji, Toyota-shi, Aichi-ken 471-8571 (JP); KAKIUCHI Eisaku, Toyota-shi, Aichi-ken 471-8571 (JP); TAKANO Yuya, Toyota-shi, Aichi-ken 471-8571 (JP); SHIBATA Yoshinori, Toyota-shi, Aichi-ken 471-8571 (JP)
(74) Representative: Albutt, Anthony John
(86) International application number: PCT/JP2009/059180
(87) International publication number: WO 2010/134160

(56) References cited:
- DE-A1- 3 731 669
- DE-B- 1 061 805
- JP-A- 2002 026 207
- JP-A- 2005 191 527
- JP-A- 2006 324 647
- JP-A- 2007 294 666

## Description

### TECHNICAL FIELD

The present invention relates to a heat exchanger for cooling a heat generating element such as a semiconductor element and others with coolant flowing inside the heat exchanger, and a manufacturing method thereof.

### BACKGROUND ART

Inverter devices having power conversion functions are used as a power source of hybrid cars and the like. Inverter devices include several semiconductor elements as switching elements. These semiconductor elements in inverter devices need to be actively cooled as they generate heat with power conversion and the like.

A known heat exchanger for cooling heat generating elements such as semiconductor elements includes, for example, a frame that forms an outer frame and a plurality of fins extending straight and arranged in parallel inside the frame to form flow channels of coolant (see, for example, Patent Document 1).

### RELATED ART DOCUMENTS

### PATENT DOCUMENTS

### Patent Document 1: JP2007-335588A

DE 37 31 669 discloses a flat heat exchanger tube having ribs which project into the tube interior and are formed from the tube material according to the preamble of claim 1.

### RELATED ART DOCUMENTS

### PATENT DOCUMENTS

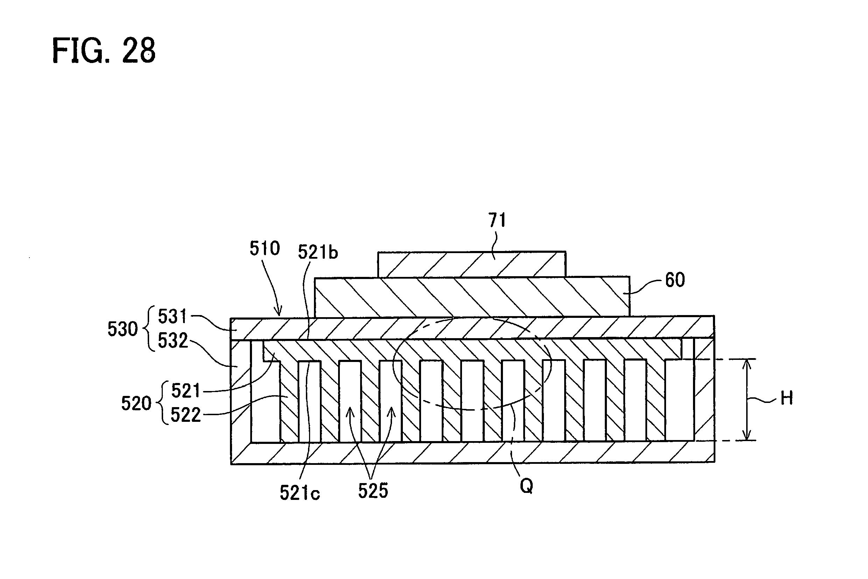

Meanwhile, heat exchangers having a fin member that is integrally formed by extrusion molding and arranged inside a frame that forms an outer frame (see FIG. 28) have been developed in recent years. In a heat exchanger 510 shown in FIG. 28, a semiconductor element 71 which is a heat generating element is placed on the outer surface of a first frame part 531 of a frame 530 via an insulating plate 60. Coolant (e.g., water) is passed through flow channels 525 formed between fins 522 of a fin member 520. The semiconductor element 71 is thereby cooled as the heat generated therein is transferred through the insulating plate 60 and the first frame part 531 to the fins 522 of the fin member 520.

The fin member 520 includes a flat plate-like base 521 and a plurality of fins 522 protruding from a back side 521c (one side) of the base 521. These fins 522 are formed in a flat plate shape extending in a fin extending direction (a direction orthogonal to the paper plane of FIG. 28) along the extruding direction of extrusion molding and arranged in a row at intervals in a fin alignment direction orthogonal to the fin extending direction (a left and right direction in FIG. 28).

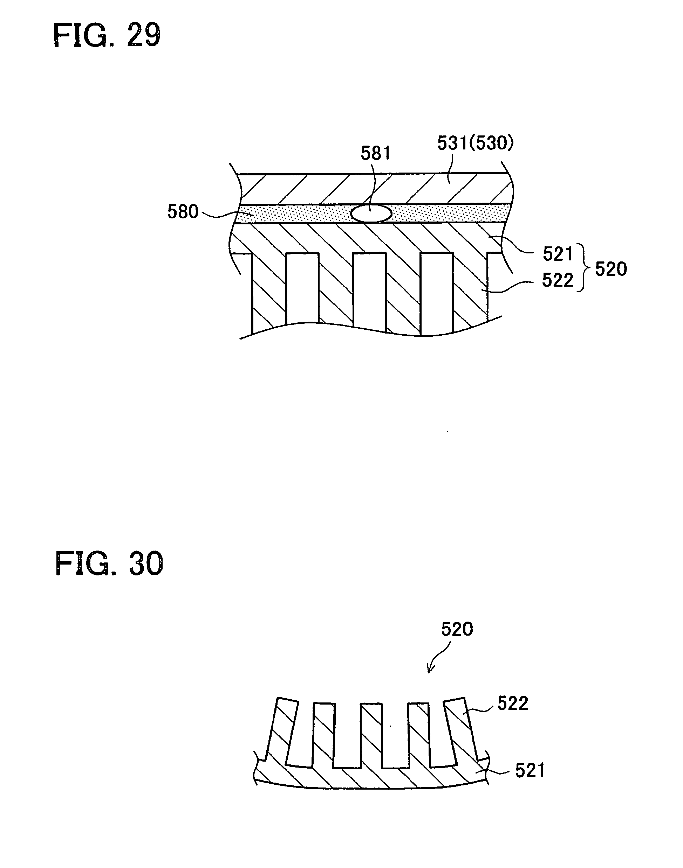

This fin member 520 is formed by, for example, welding (e.g., brazing) a front side 521b (on which the fins 522 are not arranged) of the base 521 entirely to the first frame part 531 of the frame 530. With such a welding method, however, welding is done over a wide surface so that gas generated during welding can hardly be expelled to the outside of the weld. This would sometimes allow gas to remain inside a weld 580 after welding, whereby voids (air pockets) 581 were formed as shown in FIG. 29. Such voids 581 inhibit heat transfer from the first frame part 531 to the fin member 520, because of which sufficient cooling performance is not obtained in some cases.

The protruding height of the fins should preferably be increased in order to enhance the cooling performance by the fin member. However, increasing the protruding height H of the fins 522 as with the fin member 520 would lead to a decrease in the strength of an extrusion mold used for molding the fin member (particularly, part of the extrusion mold that forms the fins would become thin and long, whereby the strength of this part would decrease). There was thus a possibility that the extrusion mold might deform during extrusion molding, deteriorating moldability of the fin member. There was also a possibility that the extrusion mold might break during extrusion molding.

The fin member immediately after extrusion molding is very hot (e.g., about 600°C) and it is cooled with cooling water or the like. However, while fins 522 of the fin member 520 cool down quickly, the base 521 does not. Such a difference in cooling speed would sometimes cause warping (bending) in the fin member 520 as shown in FIG. 30.

The present invention was devised in consideration of such circumstances, and its object is to provide a heat exchanger and a manufacturing method thereof, wherein the heat exchanger includes a fin member having good moldability of extrusion molding and being less liable to warp (bend) and wherein occurrence of voids in welds between the fin member and a frame is suppressed.

### MEANS OF SOLVING THE PROBLEMS

One aspect of the present invention is a heat exchanger in which a fin member including a plurality of fins forming coolant flow channels is arranged inside a frame forming an outer frame, wherein the fin member is a fin member integrally formed by extrusion molding, the fin member including: a rectangular flat plate-like base; a plurality of front side fins protruding from a front side of the base and each having a flat plate shape extending in a fin extending direction along an extrusion direction of the extrusion molding, the front side fins being arranged in a row at intervals in a fin alignment direction orthogonal to the fin extending direction; and a plurality of back side fins protruding from a back side of the base and each having a flat plate shape extending in the fin extending direction, the back side fins being arranged in a row at intervals in the fin alignment direction, and distal ends of at least either the front side fins or the back side fins are welded to the frame while the front side and the back side of the base are not welded to the frame.

The above-described heat exchanger uses a fin member integrally formed by extrusion molding such as to have a rectangular flat plate-like base, a plurality of front side fins protruding from the front side of the base, and a plurality of back side fins protruding from the back side of the base. Such a fin member has good moldability of extrusion molding as compared to the fin member 520 having fins 522 protruding only from the back side 521c (one side) of the base 521 (see FIG. 28). This is because, while the fin member can have equivalent cooling performance by setting the sum of the protruding height of the front side fins from the base and the protruding height of the back side fins from the base to be equal to the protruding height H of the fins 522 (with the fin thickness being equal), the respective protruding heights of the front side fins and the back side fins can be made lower than the protruding height H of the fins 522. Thereby, the length of a fin-forming part of the extrusion mold used for molding the fin member can be made shorter, so that the extrusion mold (particularly, part of the extrusion mold that forms the fins) can have higher strength. This suppresses deformation of the extrusion mold during extrusion molding and improves the moldability of the fin member.

At the time of cooling the extrusion-molded fin member having a rectangular flat plate-like base, a plurality of front side fins protruding from the front side of the base, and a plurality of back side fins protruding from the back side of the base, warping (bending) can be suppressed, as compared to the fin member 520 (see FIG. 30). This is because the above-described fin member has fast cooling fins (front side fins and back side fins) arranged on both sides (front side and back side) of the base that cools down slowly. This reduces the difference in how fast the fin member cools down (cooling speed) between the front side and the back side of the base, whereby warping (bending) of the fin member can be suppressed. Accordingly, the above-described fin member is a fin member less liable to warp (bend).

Further, in the above-described heat exchanger, the distal ends of at least either the front side fins or the back side fins are welded to the frame, but the front side and the back side of the base are not welded to the frame. Thereby, the weld surface (weld) can be made much smaller as compared to the case where the entire front side 521b of the base 521 is welded (e.g., brazed) to the frame 530 (see FIG. 29). This allows gas generated during welding (e.g., brazing) of the frame and the fin member to be readily expelled from the weld to the outside, whereby occurrence of voids (air pockets) in the weld between the fin member and the frame can be suppressed. Accordingly, the above-described heat exchanger is a heat exchanger in which occurrence of voids in welds between the fin member and the frame is suppressed. Thereby, heat transfer from the frame to the fin member can be improved.

In the heat exchanger 510 (see FIG. 28), the insulating plate 60 is welded (e.g., brazed) to the outer surface of the first frame part 531 of the frame 530. The frame 530 is made of a material having high heat conductivity (e.g., aluminum), while the insulating plate 60 is made of a material having electrical insulation properties (e.g., ceramics such as alumina). Therefore, the frame 530 (first frame part 531) and insulating plate 60 have largely different linear expansion coefficients. For this reason, when the frame and the insulating plate are cooled after being heated at the time of welding (e.g., brazing) the frame and the insulating plate, warping (bending) would sometimes occur due to the difference in shrinkage rate (linear expansion coefficient) between the frame and insulating plate. With the heat exchanger 510 (see FIG. 28), in particular, part of the frame where the insulating plate is welded has higher strength because the first frame part 531 of the frame 530 is united with the base 521 of the fin member 520 by welding (e.g., brazing). It was therefore liable to the above-described warping (bending).

In contrast, with the above-described heat exchanger, the distal ends of at least either the front side fins or the back side fins are welded to the frame, but the front side and the back side of the base are not welded to the frame. Thereby, part of the frame where insulating plates are welded has lower strength as compared to the heat exchanger 510, so that the above-described warping (bending) can be suppressed.

Welding herein refers to a joining technique that involves heating and melting, including brazing with the use of brazing material, soldering with the use of solder, and other joining methods involving melting of the base material (components to be joined together).

Further, in the above-described heat exchanger, preferably, a plurality of fin members having the same shape are arranged with their fin extending directions all coinciding with each other and in a row at intervals in a flow direction of the coolant along the fin extending direction, the fin members have the front side fins and the back side fins arranged at equal and regular intervals in the fin alignment direction, the front side fins of the fin members adjacent to each other in the fin extending direction are arranged offset from each other by just half of the interval in the fin alignment direction, and the back side fins of the fin members adjacent to each other in the fin extending direction are arranged offset from each other by just half of the interval in the fin alignment direction.

Meanwhile, as a result of an investigation of the speed distribution of coolant flowing between fins in heat exchangers having fin members with plural fins that form coolant flow channels arranged inside a frame that forms an outer frame, it was found that the coolant tends to slow down as it approaches the fins. This is because the coolant is pulled toward the fins due to the effect of viscosity of the coolant. Because of this, there is created a region where the coolant speed is slower or the coolant substantially stagnates as compared to other regions (hereinafter referred to also as "interface layer") near the fins. Once this interface layer is created, the fins in which heat has been collected exchange heat only with the coolant present in the interface layer primarily formed around the fins and hardly exchange heat with coolant flowing in regions other than the interface layer. This resulted in the problem that a high cooling effect was not achieved due to the lack of efficient heat exchange with coolant flowing inside the heat exchanger.

In this respect, in the above-described heat exchanger, the front side fins of the fin members adjacent to each other in the fin extending direction (adjacent to upstream and downstream of the flow channel extending along the fin extending direction) are offset from each other by just half of the interval therebetween in the fin alignment direction. In other words, the front side fins of the fin members adjacent to each other in the fin extending direction are offset from each other in the fin alignment direction. Further, the back side fins of the fin members adjacent to each other in the fin extending direction are also offset from each other by just half of the interval therebetween in the fin alignment direction. In other words, the back side fins of the fin members adjacent to each other in the fin extending direction are also offset from each other in the fin alignment direction.

Thereby, the coolant flowing through flow channels (e.g., flow channels on the front side of the fin member) can be made to collide an end face on the upstream side of the fin member (e.g., end face on the upstream side of a front side fin) located downstream and split into two flow channels (e.g., two flow channels adjacent to each other in the fin alignment direction via a front side fin) bifurcated by a front side fin or a back side fin, and flow channels located on the opposite side (e.g., back side) of the base. This creates turbulence in the coolant flow and effectively suppresses formation of the interface layer. This enables efficient use of the coolant flowing inside the heat exchanger, whereby a high cooling effect can be achieved.

Further, in the above-described heat exchanger, preferably, a plurality of fin members having the same shape are arranged with their fin extending directions all coinciding with each other and in a row at intervals in a flow direction of the coolant along the fin extending direction, the fin members have the front side fins and the back side fins arranged at equal and regular intervals in the fin alignment direction, the front side fins and the back side fins are arranged offset from each other by just half of the interval in the fin alignment direction, and the plurality of fin members are aligned in the coolant flow direction with the front side and the back side of their bases being oriented alternately oppositely.

The fin members used in the above-described heat exchanger have their front side fins and back side fins arranged offset from each other by just half of the interval between the fins in the fin alignment direction. Further, the fin members are aligned in the coolant flow direction (fin extending direction), with the front and back sides of their bases being oriented alternately oppositely. Thereby, the front side fins and the back side fins of the fin members adjacent to each other in the fin extending direction can be arranged offset from each other by just half of the interval therebetween in the fin alignment direction.

Thereby, the coolant flowing through flow channels (e.g., flow channels on the front side of the fin member) can be made to collide an end face on the upstream side of the fin member (e.g., end face on the upstream side of a front side fin) located downstream and split into two flow channels (e.g., two flow channels adjacent to each other in the fin alignment direction via a front side fin) bifurcated by a front side fin or a back side fin, and flow channels located on the opposite side (e.g., back side) of the base. This creates turbulence in the coolant flow and effectively suppresses formation of the interface layer. This enables efficient use of the coolant flowing inside the heat exchanger, whereby a high cooling effect can be achieved.

Moreover, in the above-described fin member, the back side fins are not present at symmetrically opposite positions of the front side fins with respect to the base. In addition, the front side fins are not present at symmetrically opposite positions of the back side fins with respect to the base. Therefore, as compared to a heat exchanger using a fin member in which back side fins are present at symmetrical positions of the front side fins with respect to the base, the coolant flowing through flow channels (e.g., flow channels on the front side of the fin member) can be readily split into the flow channels located on the opposite side (e.g., back side) of the base when it collides an end face on the upstream side of the fin member (e.g., end face on the upstream side of a front side fin) located downstream. This promotes creation of turbulence in the coolant thereby to further suppress formation of the interface layer.

Further, in any of the above-described heat exchangers, preferably, a plurality of fin members having the same shape are arranged with their fin extending directions all coinciding with each other and in a row at intervals in a flow direction of the coolant along the fin extending direction, the fin members have the plurality of front side fins of the same shape and the plurality of back side fins of the same shape, the front side fins and the back side fins being different in protruding height from each other, and the plurality of fin members are arranged in the coolant flow direction with the front and back sides of their bases being oriented alternately oppositely.

The above-described heat exchanger uses, as the fin member, a fin member having a plurality of front side fins of the same shape and a plurality of back side fins of the same shape with their protruding heights being different from each other. Moreover, these fin members are aligned in the coolant flow direction (fin extending direction) with the front and back sides of their bases being oriented alternately oppositely. Thereby, the bases of the fin members adjacent to each other in the fin extending direction can be offset from each other (fin members can be arranged such that their bases are offset from each other in a direction orthogonal to the surface of the base). Therefore, the coolant flowing through flow channels can readily collide with an end face on the upstream side of a base of the fin member located downstream and split into two flow channels located on the front side and back side of the base. This promotes creation of turbulence in the coolant and suppresses formation of the interface layer, whereby the coolant flowing inside the heat exchanger can be used efficiently so that a high cooling effect can be achieved.

Further, in any of the above-described heat exchangers, preferably, the fin member has the front side fins and back side fins symmetrical with each other with respect to the base.

The above-described heat exchanger uses, as the fin member, a fin member having its front side fins and back side fins symmetrical with each other with respect to the base. Such a fin member has particularly good moldability of extrusion molding as compared to the fin member 520 having fins 522 protruding only from the back side 521c (one side) of the base 521 (see FIG. 28). This is because, while the fin member can have equivalent cooling performance by setting the sum of the protruding height of the front side fins from the base and the protruding height of the back side fins from the base to be equal to the protruding height H of the fins 522 (with the fin thickness being equal), the respective protruding heights of the front side fins and the back side fins can be reduced to half of the protruding height H of the fins 522. Thereby, the length of a fin-forming part of the extrusion mold used for molding the fin member can be reduced by half, and the extrusion mold (particularly, part of the extrusion mold that forms the fins) can have higher strength. This suppresses deformation of the extrusion mold during extrusion molding and improves the moldability of the fin member.

Also, warping (bending) can be prevented at the time of cooling the above-described extrusion-molded fin member. This is because, in the above-described fin member, the front side fins and the back side fins having the same shape (and thus equal cooling speed) are arranged at symmetrical positions with respect to the base. This makes the cooling speed of the fin member equal on the front side and back side of the base so that warping (bending) of the fin member can be prevented. Therefore the above-described fin member is a warp (bend) resistant fin member.

Further, in any of the above-described heat exchangers, preferably, a plurality of fin members having the same shape are arranged with their fin extending directions all coinciding with each other and in a row at intervals in a flow direction of the coolant along the fin extending direction, the fin members have the front side fins and the back side fins protruding obliquely toward the same side in the fin alignment direction, and the plurality of fin members are arranged relative to each other such that their front side fins and back side fins incline toward the same side, one end faces of the bases in the fin alignment direction being abutted on a flat inner wall surface of one side wall of the frame in the fin alignment direction.

In the above-described heat exchanger, the plurality of fin members having the same shape are arranged in a row in the coolant flow direction along the fin extending direction, their fin extending directions all coinciding with each other. It is sometimes required, in such a heat exchanger, that the plurality of fin members be aligned straight in a row in the coolant flow direction without being displaced from each other in the fin alignment direction (the direction orthogonal to the coolant flow direction).

In this respect, in the above-described heat exchanger, with respect to the plurality of fin members arranged in a row in the coolant flow direction along the fin extending direction, one end face in the fin alignment direction of the bases is abutted on the flat inner wall surface of one side wall in the fin alignment direction of the frame. Thereby, the plurality of fin members arranged in a row in the coolant flow direction are aligned straight in a row along the flat inner wall surface of one side wall of the frame. Therefore, the plurality of fin members are aligned straight in a row in the coolant flow direction without being displaced from each other in the fin alignment direction (the direction orthogonal to the coolant flow direction).

One end face in the fin alignment direction of the bases of the plurality of fin members is abutted on the flat inner wall surface of one side wall in the fin alignment direction of the frame by the following technique: With respect to the plurality of fin members arranged inside the frame, the distal ends of the front side fins are pressed toward the front side of the base through the frame, as well as the distal ends of the back side fins are pressed toward the back side of the base through the frame. Thereby, the front side fins and the back side fins are compressed and deformed so that a force can be applied that acts to move the base ends (part on the base side, opposite from the distal ends) of the front side fins and the back side fins toward the opposite side from the side toward which the front side fins and the back side fins are inclined in the fin alignment direction. Thereby, the base can be moved toward the opposite side from the side toward which the front side fins and the back side fins are inclined in the fin alignment direction, to cause one end face in the fin alignment direction of the base (particularly, the opposite side from the side toward which the front side fins and the back side fins are inclined in the fin alignment direction) to abut on the flat inner wall surface of one side wall of the frame in the fin alignment direction (particularly, the opposite side from the side toward which the front side fins and the back side fins are inclined in the fin alignment direction).

Another aspect of the present invention is a method of manufacturing a heat exchanger in which a fin member including a plurality of fins forming coolant flow channels is arranged inside a frame forming an outer frame, the method including: an extrusion molding step of integrally forming the fin member by extrusion molding; an arranging step of arranging the fin member molded in the extrusion molding step inside the frame; and a joining step of welding the frame and the fin member arranged inside the frame, wherein the extrusion molding step includes integrally forming the fin member by extrusion molding, the fin member including: a rectangular flat plate-like base; a plurality of front side fins protruding from a front side of the base and having a flat plate shape extending in a fin extending direction along an extrusion direction of the extrusion molding, the front side fins being arranged in a row at intervals in a fin alignment direction orthogonal to the fin extending direction; and a plurality of back side fins protruding from a back side of the base and having a flat plate shape extending in the fin extending direction along the extrusion direction of the extrusion molding, the back side fins being arranged in a row at intervals in the fin alignment direction, and the joining step includes welding distal ends of at least either the front side fins or the back side fins to the frame without welding the front side and the back side of the base to the frame.

In the above-described manufacturing method, the fin member including a flat plate-like base, a plurality of front side fins protruding from a front side of the base, and back side fins protruding from a back side of the base, is integrally formed by extrusion molding. Moldability of extrusion molding of a fin member having such a form is good as compared to the fin member 520 having fins 522 protruding only from the back side 521c (one side) of the base 521 (see FIG. 28). The reason is as described in the foregoing. Further, because the fin member has the above-described form, warping (bending) can be suppressed at the time of cooling the extrusion-molded fin member, as compared to the fin member 520 (see FIG. 30). The reason is as described in the foregoing.

Further, in the above-described manufacturing method, the distal ends of at least either the front side fins or the back side fins are welded to the frame, but the front side and the back side of the base are not welded to the frame. Thereby, the weld surface (weld) can be made much smaller as compared to the case where the entire front side 521b of the base 521 is welded (e.g., brazed) to the frame 530 (see FIG. 29). This allows gas generated during welding (e.g., brazing) of the frame and the fin member to be readily expelled from the weld to the outside, whereby occurrence of voids (air pockets) in the weld between the fin member and the frame can be suppressed. Thereby, heat transfer from the frame to the fin member can be improved.

Also, by welding the distal ends of at least either the front side fins or the back side fins to the frame without welding the front side and the back side of the base to the frame, as described in the foregoing, part of the frame where insulating plates are welded can have lower strength as compared to the heat exchanger 510. Thereby, warping (bending) caused by a difference in shrinkage rate (linear expansion coefficient) between the frame and the insulating plates can be suppressed.

Welding methods applicable in the joining step include, for example, a method of brazing the frame and the fin member, a method of soldering the frame and the fin member, and methods whereby the frame and the fin member are joined together by melting their joint (such as laser welding, electron beam welding, and resistance welding).

Further, in the above-described heat exchanger manufacturing method, preferably, the extrusion molding step includes integrally forming the fin member by extrusion molding, the fin member having the front side fins and the back side fins arranged at equal and regular intervals in the fin alignment direction, and the arranging step includes arranging a plurality of fin members having the same shape with their fin extending directions coinciding with each other and in a row at intervals in the coolant flow direction along the fin extending direction, the arranging step including arranging the fin members so that the front side fins of the fin members adjacent to each other in the fin extending direction are offset from each other by just half of the interval in the fin alignment direction and the back side fins of the fin members adjacent to each other in the fin extending direction are offset from each other by just half of the interval in the fin alignment direction.

In the above-described manufacturing method, the front side fins of the fin members adjacent to each other in the fin extending direction (adjacent to upstream and downstream of the flow channel extending along the fin extending direction) are arranged offset from each other by just half of the interval therebetween in the fin alignment direction. In other words, the front side fins of the fin members adjacent to each other in the fin extending direction are offset from each other in the fin alignment direction. Further, the back side fins of the fin members adjacent to each other in the fin extending direction are also arranged offset from each other by just half of the interval therebetween in the fin alignment direction. In other words, the back side fins of the fin members adjacent to each other in the fin extending direction are also offset from each other in the fin alignment direction.

Thereby, the coolant flowing through flow channels (e.g., flow channels on the front side of the fin member) can be made to collide an end face on the upstream side of the fin member (e.g., end face on the upstream side of a front side fin) located downstream and split into two flow channels (e.g., two flow channels adjacent to each other in the fin alignment direction via a front side fin) bifurcated by a front side fin or a back side fin and flow channels located on the opposite side (e.g., back side) of the base. This creates turbulence in the coolant flow and effectively suppresses formation of the interface layer. This enables efficient use of the coolant flowing inside the heat exchanger, whereby a high cooling effect can be achieved.

Further, in the above-described heat exchanger manufacturing method, preferably, the extrusion molding step includes integrally forming the fin member by extrusion molding, the fin member having the front side fins and the back side fins arranged at equal and regular intervals in the fin alignment direction, the front side fins and the back side fins being arranged offset from each other by just half of the interval in the fin alignment direction, and the arranging step includes arranging a plurality of fin members having the same shape with their fin extending directions coinciding with each other and in a row at intervals in the coolant flow direction along the fin extending direction, the arranging step including aligning the plurality of fin members straight in a row in the coolant flow direction, with the front and back sides of their bases being oriented alternately oppositely.

In the above-described manufacturing method, the fin member having their front side fins and back side fins arranged offset from each other by just half of the interval between the fins in the fin alignment direction is integrally formed by extrusion molding. Further, these fin members are aligned straight in a row in the coolant flow direction (fin extending direction), with the front and back sides of their bases being oriented alternately oppositely. Thereby, the front side fins and the back side fins of the fin members adjacent to each other in the fin extending direction can be arranged offset from each other by just half of the interval therebetween in the fin alignment direction.

Thereby, the coolant flowing through flow channels (e.g., flow channels on the front side of the fin member) can be made to collide an end face on the upstream side of the fin member (e.g., end face on the upstream side of a front side fin) located downstream and split into two flow channels (e.g., two flow channels adjacent to each other in the fin alignment direction via a front side fin) bifurcated by a front side fin or a back side fin, and flow channels located on the opposite side (e.g., back side) of the base. This creates turbulence in the coolant flow and effectively suppresses formation of the interface layer. This enables efficient use of the coolant flowing inside the heat exchanger, whereby a high cooling effect can be achieved.

Moreover, in the above-described fin member, the back side fins are not present at symmetrically opposite positions of the front side fins with respect to the base, and further, the front side fins are not present at symmetrically opposite positions of the back side fins with respect to the base. Therefore, as compared to a heat exchanger using a fin member in which back side fins are present at symmetrical positions of the front side fins with respect to the base, the coolant flowing through flow channels (e.g., flow channels on the front side of the fin member) can be readily split into flow channels located on the opposite side (e.g., back side) of the base when it collides an end face on the upstream side of the fin member (e.g., end face on the upstream side of a front side fin) located downstream. This promotes creation of turbulence in the coolant thereby to further suppress formation of the interface layer.

Further, in any of the above-described heat exchanger manufacturing methods, preferably, the extrusion molding step includes integrally forming the fin member by extrusion molding, the fin member having the plurality of front side fins of the same shape and the plurality of back side fins of the same shape, the font side fins and the back side fins being different in protruding height from each other; and the arranging step includes arranging a plurality of fin members having the same shape with their fin extending directions coinciding with each other and in a row at intervals in the coolant flow direction along the fin extending direction, the arranging step including aligning the plurality of fin members in the coolant flow direction with the front and back sides of their bases being oriented alternately oppositely.

In the above-described manufacturing method, the fin member having a plurality of front side fins of the same shape and a plurality of back side fins of the same shape with their protruding heights being different from each other is integrally formed by extrusion molding. Moreover, these fin members are aligned in the coolant flow direction (fin extending direction) with the front and back sides of their bases being oriented alternately oppositely. Thereby, the bases of the fin members adjacent to each other in the fin extending direction can be offset from each other (fin members can be arranged such that their bases are offset from each other in a direction orthogonal to the surface of the base). Therefore, the coolant flowing through flow channels can readily collide with an end face on the upstream side of a base of the fin member located downstream and split into two flow channels located on the front side and back side of the base. This promotes creation of turbulence in the coolant and suppresses formation of the interface layer, whereby the coolant flowing inside the heat exchanger can be used efficiently so that a high cooling effect is achieved.

Further, in any of the above-described heat exchanger manufacturing methods, preferably, the extrusion molding step includes integrally forming the fin member by extrusion molding, the fin member having the front side fins and the back side fins symmetrical with each other with respect to the base.

In the above-described manufacturing method, the fin member having its front side fins and back side fins symmetrical with each other with respect to the base is integrally formed by extrusion molding. Moldability of extrusion molding of a fin member having such a form is particularly good as compared to the fin member 520 having fins 522 protruding only from the back side 521c (one side) of the base 521 (see FIG. 28). The reason is as described in the foregoing.

Further, warping (bending) can be suppressed at the time of cooling the extrusion-molded fin member. The reason is as described in the foregoing.

Further, in any of the above-described heat exchanger manufacturing methods, preferably, the extrusion molding step includes integrally forming the fin member by extrusion molding, the fin member having the front side fins and the back side fins protruding obliquely toward the same side in the fin alignment direction, the arranging step includes arranging a plurality of fin members having the same shape with their fin extending directions all coinciding with each other and in a row in the coolant flow direction along the fin extending direction, the arranging step including arranging the plurality of fin members inside the frame such that the front side fins and the back side fins of the fin members incline toward the same side, and the joining step includes welding the frame and the plurality of fin members located inside the frame while pressing the distal ends of the front side fins toward the front side of the base through the frame and pressing the distal ends of the back side fins toward the back side of the base through the frame, and abutting one end faces of the bases in the fin alignment direction on a flat inner wall surface of one side wall of the frame in the fin alignment direction.

In the above-described manufacturing method, in the arranging step, the plurality of fin members having the same shape are arranged in a row in the coolant flow direction along the fin extending direction, their fin extending directions all coinciding with each other. It is sometimes required, in such an arranging step, that the plurality of fin members be aligned straight in a row in the coolant flow direction without being displaced from each other in the fin alignment direction (the direction orthogonal to the coolant flow direction).

In this respect, in the above-described manufacturing method, the fin member having the front side fins and the back side fins protruding obliquely (at a slant) toward the same side in the fin alignment direction is integrally formed by extrusion molding. These fin members are arranged inside the frame relative to each other such that their front side fins and the back side fins incline toward the same side. After that, with respect to the plurality of fin members arranged inside the frame, the distal ends of the front side fins are pressed toward the front side of the base via the frame, and the distal ends of the back side fins are pressed toward the back side of the base via the frame.

Thereby, the front side fins and the back side fins are compressed and deformed so that a force can be applied that acts to move the base ends (part on the base side, opposite from the distal ends) of the front side fins and the back side fins toward the opposite side from the side toward which the front side fins and the back side fins are inclined in the fin alignment direction. Thereby, the base can be moved toward the opposite side from the side toward which the front side fins and the back side fins are inclined in the fin alignment direction, to cause one end face in the fin alignment direction of the base (particularly, the opposite side from the side toward which the front side fins and the back side fins are inclined in the fin alignment direction) to abut on the flat inner wall surface of one side wall of the frame in the fin alignment direction (particularly, the opposite side from the side toward which the front side fins and the back side fins are inclined in the fin alignment direction).

Thus the plurality of fin members arranged in a row in the coolant flow direction can be aligned straight in a row along the flat inner wall surface of one side wall of the frame. In the above-described manufacturing method, the frame and the fin members are welded together in this state, so that "the heat exchanger with a plurality of fin members aligned straight in a row in the coolant flow direction without being displaced in the fin alignment direction (the direction orthogonal to the coolant flow direction)" can be manufactured.

### BRIEF DESCRIPTION OF THE DRAWINGS

FIG. 1 is a perspective view of a heat exchanger of Example 1;
FIG. 2 is a perspective view of a fin member of the heat exchanger of Example 1;
FIG. 3 is a view to explain an extrusion molding step of Example 1;
FIG. 4 is a cross sectional view of an extrusion mold of Example 1;
FIG. 5 is a view to explain an extrusion molding step of Example 1;
FIG. 6 is a view (a cross sectional view) to explain an arranging step and a joining step of Example 1;
FIG. 7 is a view to explain the joining step of Example 1, corresponding to an enlarged view of a part M in FIG. 6;
FIG. 8 is a perspective view of a semiconductor device of Example 1;
FIG. 9 is a perspective view of a heat exchanger of Example 2;
FIG. 10 is a cross sectional view of the heat exchanger of Example 2;
FIG. 11 is a view to explain the flow of coolant (water) in the heat exchanger of Example 2;
FIG. 12 is a perspective view of a heat exchanger of Example 3;
FIG. 13 is a perspective view of a fin member of the heat exchanger of Example 3;
FIG. 14 is a cross sectional view of the heat exchanger of Example 3;
FIG. 15 is a view to explain the flow of coolant (water) in the heat exchanger of Example 3;
FIG. 16 is a view to explain an extrusion molding step of Example 3;
FIG. 17 is a perspective view of a heat exchanger of Example 4;
FIG. 18 is a perspective view of a fin member of the heat exchanger of Example 4;
FIG. 19 is a view to explain the flow of coolant (water) in the heat exchanger of Example 4;
FIG. 20 is a view to explain an extrusion molding step of Example 4;
FIG. 21 is a perspective view of a heat exchanger of Example 5;
FIG. 22 is a front view of a fin member of Example 5;
FIG. 23 is a cross sectional view of the heat exchanger of Example 5;
FIG. 24 is a view to explain an extrusion molding step of Example 5;
FIG. 25 is a view to explain an arranging step of Example 5;
FIG. 26 is a view to explain the arranging step of Example 5;
FIG. 27 is a view to explain a joining step of Example 5;
FIG. 28 is a cross sectional view of a heat exchanger different from the present invention;
FIG. 29 is a view to explain the occurrence of voids in the heat exchanger, corresponding to an enlarged view of a part Q in FIG. 28; and
FIG. 30 is a view showing a state of warping (bending) of a fin member in the heat exchanger.

### DESCRIPTION OF THE REFERENCE SIGNS

### (Example 1)

Next, Example 1 of the present invention will be described with reference to the drawings.

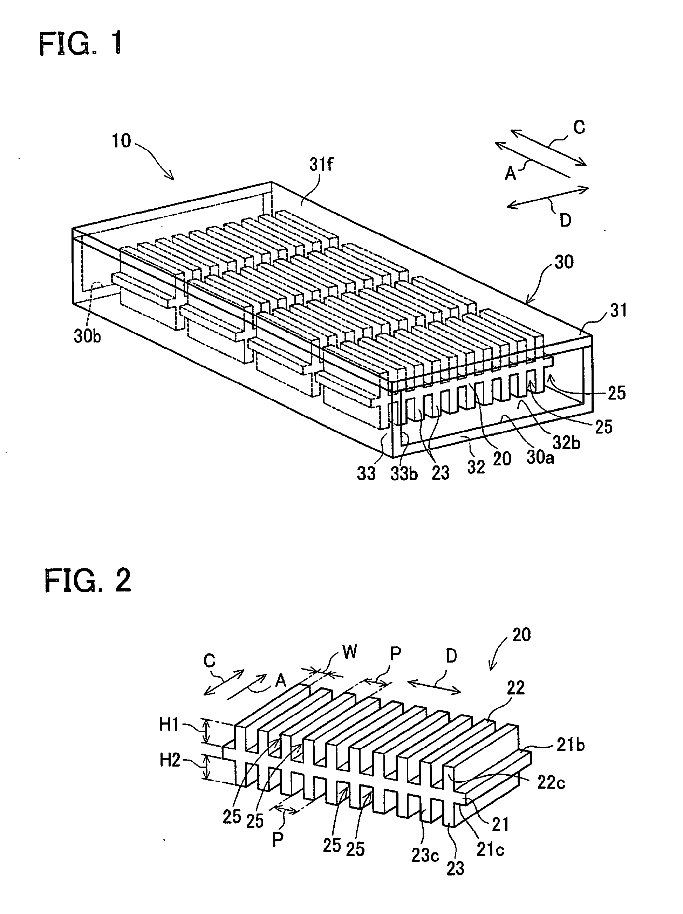

The heat exchanger 10 of Example 1 includes, as shown in FIG. 1, a frame 30 forming an outer frame, and fin members 20 accommodated inside the frame 30. The frame 30 and the fin members 20 are joined together by brazing.

In FIG. 1, the direction A indicates a flow direction of coolant (e.g., water) flowing inside the heat exchanger 10. The direction C indicates a fin extending direction of the fin members 20, and the direction D indicates a fin alignment direction of the fin members 20, which is orthogonal to the fin extending direction C. The direction A extends along the direction C.

Each fin member 20 is made of aluminum and includes, as shown in FIG. 2, a base 21 in a rectangular flat plate shape, a plurality of (ten in Example 1) front side fins 22 protruding from a front side 21b of the base 21, and a plurality of (ten in Example 1) back side fins 23 protruding from a back side 21c of the base 21. This fin member 20 is integrally formed by extrusion molding. The front side fins 22 are formed in a rectangular flat plate shape extending in the fin extending direction C along the extrusion direction of extrusion molding, and are arranged in a row at regular intervals in the fin alignment direction D orthogonal to the fin extending direction C. The back side fins 23 are also formed in a rectangular flat plate shape (same shape as the front side fins 22) extending in the fin extending direction C, and are arranged in a row at regular intervals in the fin alignment direction D orthogonal to the fin extending direction C.

The interval (pitch) between the front side fins 22 is made equal to the interval (pitch) between the back side fins 23 (interval P). The thickness of the front side fins 22 is made equal to the thickness of the back side fins 23 (thickness W). This fin member 20 forms coolant flow channels 25 of a constant width in between the front side fins 22 adjacent to each other in the fin alignment direction D, and in between the back side fins 23 adjacent to each other in the fin alignment direction D for guiding coolant in the coolant flow direction A along the fin extending direction C.

Such a fin member 20 has good moldability of extrusion molding as compared to the fin member 520 having fins 522 protruding only from the back side 521c (one side) of the base 521 (see FIG. 28). This is because, while the fin member can have equivalent cooling performance by setting the sum (H1 + H2) of the protruding height of the front side fins 22 from the base 21 and the protruding height of the back side fins 23 from the base 21 to be equal to the protruding height H of the fins 522 (with the fin thickness W being equal), the respective protruding heights H1 and H2 of the front side fins 22 and the back side fins 23 can be made lower than the protruding height H of the fins 522. Thereby, the extrusion mold used for molding the fin member (particularly, part of the extrusion mold that forms the fins) can have higher strength, whereby deformation of the extrusion mold during extrusion molding is suppressed and the moldability of the fin member is improved.

In addition, the fin member 20 of Example 1 has a shape in which the front side fins 22 and back side fins 23 are symmetrical (vertically symmetrical in FIG. 2) with respect to the base 21. Such a fin member 20 has particularly good moldability of extrusion molding as compared to the fin member 520 having fins 522 protruding only from the back side 521c (one side) of the base 521 (see FIG. 28). This is because, while the fin member can have equivalent cooling performance by setting the sum (H1 + H2) of the protruding height of the front side fins 22 from the base and the protruding height of the back side fins 23 from the base to be equal to the protruding height H of the fins 522 (with the fin thickness W being equal), the respective protruding heights H1 and H2 of the front side fins 22 and the back side fins 23 can be reduced to half of the protruding height H of the fins 522. Thereby, the extrusion mold used for molding the fin member (particularly, part of the extrusion mold that forms the fins) can have higher strength, whereby deformation of the extrusion mold during extrusion molding is suppressed and the moldability of the fin member is improved.

The fin member 20 of Example 1 is also a fin member less liable to warp (bend) as compared to the fin member 520 (see FIG. 30). Namely, warping (bending) can be suppressed at the time of cooling the extrusion-molded fin member, as compared to the fin member 520 (see FIG. 30). This is because the fin member 20 of Example 1 has fast cooling fins (front side fins 22 and back side fins 23) arranged on both sides (front side 21b and back side 21c) of the base 21 that cools down slowly. This reduces the difference in how fast the fin member cools down (cooling speed) between the front side 21b and the back side 21c of the base 21, whereby warping (bending) of the fin member can be suppressed.

In Example 1, in particular, the fin member 20 has a shape in which the front side fins 22 and the back side fins 23 are symmetrical (vertically symmetrical in FIG. 2) with respect to the base 21. Namely, the front side fins 22 and the back side fins 23 having the same shape (and thus equal cooling speed) are arranged at symmetrical positions with respect to the base 21. This makes the cooling speed of the fin member equal on the front side 21b and back side 21c of the base 21 so that warping (bending) of the fin member can be prevented. Therefore the fin member 20 of Example 1 is a warp (bend) resistant fin member.

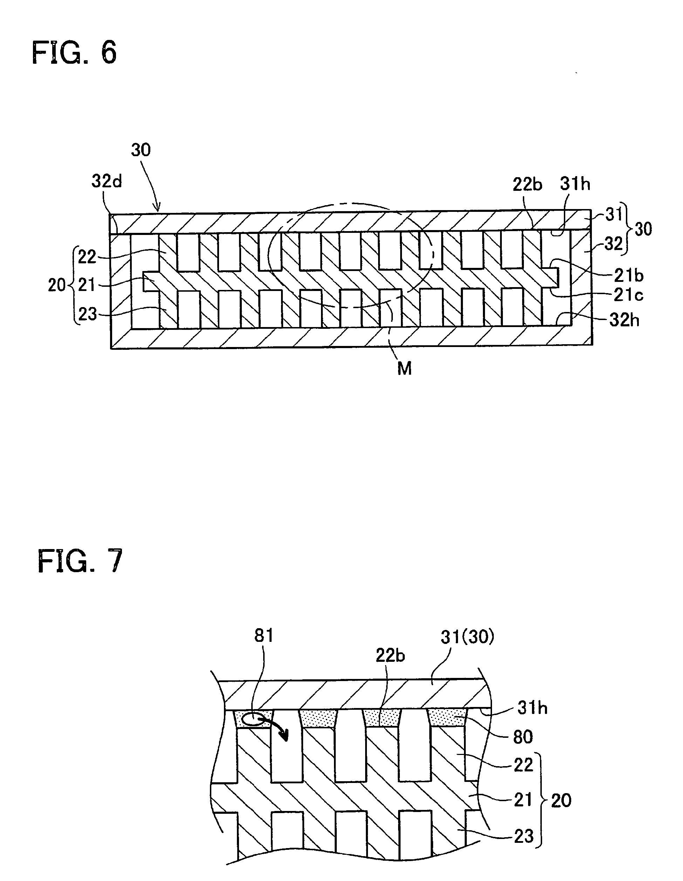

The frame 30 includes an aluminum-made first frame part 31 in a rectangular flat plate shape, and an aluminum-made second frame part 32 having a square U-shaped cross section (see FIG. 1 and FIG. 6). The first frame part 31 and the second frame part 32 are joined together by brazing. Thereby, the frame 30 takes on a rectangular cylindrical shape. This frame 30 has an inlet port 30a for introducing coolant at one end in the longitudinal direction (coinciding with the direction A) and an outlet port 30b for discharging coolant at the other end in the longitudinal direction (coinciding with the direction A).

Further, in the heat exchanger 10 of Example 1, the fin member 20 is welded (brazed in Example 1) to the first frame part 31 of the frame 30 at distal ends 22b of the front side fins 22 (see FIG. 7). That is, the distal ends 22b of the front side fins 22 are welded (brazed in Example 1) to the frame 30, but the front side 21b and the back side 21c of the base 21 are not welded to the frame 30.

Thereby, the weld surface (weld 80) can be made much smaller as compared to the case where the entire front side 521b of the base 521 is welded (e.g., brazed) to the frame 530 (see FIG. 29). This allows gas 81 generated during welding (e.g., brazing) of the frame 30 and the fin member 20 to be readily expelled from the weld 80 to the outside, whereby occurrence of voids (air pockets) in the weld 80 between the fin member 20 and the frame 30 can be suppressed. Accordingly, the heat exchanger 10 of Example 1 is a heat exchanger in which occurrence of voids in the weld 80 between the fin member 20 and the frame 30 is suppressed. Thereby, heat transfer from the frame 30 to the fin member 20 can be improved.

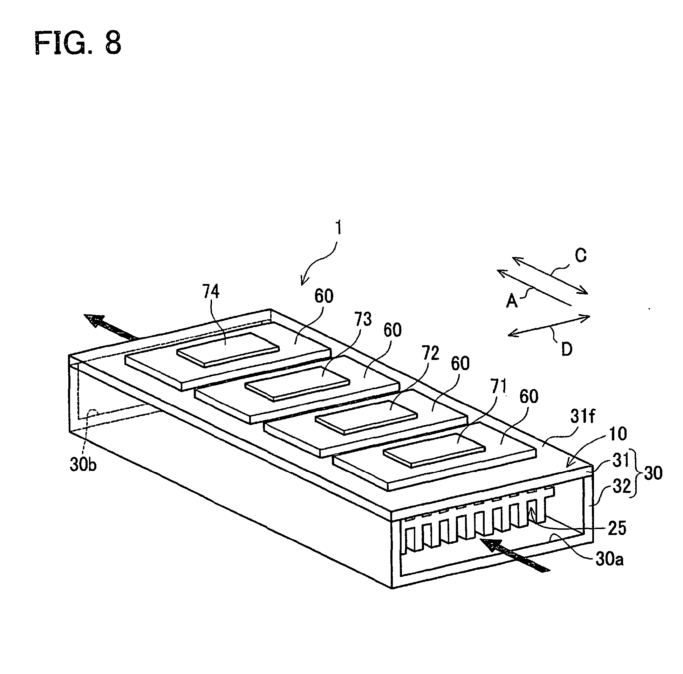

The heat exchanger 10 of Example 1 can be used for cooling, for example, semiconductor elements. More specifically, as shown in FIG. 8, for example, a semiconductor device 1 is configured with the heat exchanger 10, insulating plates 60 arranged at four positions on an outer surface 31f of the first frame part 31, and semiconductor elements 71 to 74 arranged respectively on the surfaces of the insulating plates 60. The insulating plates 60 are made of a material having electrical insulation properties (e.g., ceramics such as alumina) and formed in a rectangular flat plate shape. The four insulating plates 60 are regularly spaced apart and aligned in a row along the longitudinal direction (coinciding with the direction A) of the first frame part 31. These insulating plates 60 are joined to the outer surface 31f of the first frame part 31 by brazing. The semiconductor elements 71 to 74 are soldered to the surface of the insulating plates 60.

Now, the insulating plates 60 and the frame 30 (first frame part 31) have different linear expansion coefficients. More specifically, if the insulating plates 60 used are made of alumina, for example, they have a linear expansion coefficient of about 7 x 10⁻⁶/°C. On the other hand, the aluminum-made frame 30 (first frame part 31) has a linear expansion coefficient of about 23 x 10⁻⁶/°C. In the case of this example, the frame 30 (first frame part 31) has a linear expansion coefficient more than three times larger than that of the insulating plates 60.

For this reason, when the frame and the insulating plates are cooled after being heated at the time of welding (e.g., brazing) the alumina-made insulating plates and the aluminum-made frame (first frame part), warping (bending) would sometimes occur due to the difference in shrinkage rate (linear expansion coefficient) between the frame and the insulating plates. With the heat exchanger 510 (see FIG. 28), in particular, part of the frame where the insulating plate is welded has higher strength because the first frame part 531 of the frame 530 is united with the base 521 of the fin member 520 by welding (e.g., brazing). It was therefore liable to cause the above-described warping (bending).

In contrast, with the heat exchanger 10 of Example 1, as described above, the distal ends 22b of the front side fins 22 are welded (brazed in Example 1) to the frame 30, but the front side 21b and the back side 21c of the base 21 are not welded to the frame 30 (see FIG. 6). Thereby, part of the frame where insulating plates are welded has lower strength as compared to the heat exchanger 510, so that the above-described warping (bending) can be suppressed. FIG. 6 is a cross section of the heat exchanger 10 cut in a direction orthogonal to the direction A.

Now, the cooling effect by the heat exchanger 10 of Example 1 in association with the semiconductor device 1 (see FIG. 8) will be described. The semiconductor elements 71 to 74 generate heat as they operate. The heat is transferred through the insulating plates 60 to the frame 30 (first frame part 31) and further to the front side fins 22 and back side fins 23 of the fin members 20 accommodated inside the frame 30.

Coolant (e.g., water) is continuously introduced through the inlet port 30a into the frame 30 as indicated by the arrow in FIG. 8. The coolant introduced into the frame 30 flows in the direction A (along the fin extending direction C) through the flow channels 25 formed between the front side fins 22 and the back side fins 23 adjacent to each other in a direction along the fin alignment direction D.

Thereby, the front side fins 22 and back side fins 23 of the fin members 20 can exchange heat with the coolant flowing through the flow channels 25. That is, heat transferred from the semiconductor elements 71 to 74 to the front side fins 22 and the back side fins 23 can be released into the coolant flowing through the flow channels 25. The coolant that has absorbed heat from the front side fins 22 and the back side fins 23 as it flows through the flow channels 25 is discharged to the outside of the frame 30 through the outlet port 30b. Thus the heat generating semiconductor elements 71 to 74 can be adequately cooled.

Next, a manufacturing method of the heat exchanger 10 according to Example 1 will be described.

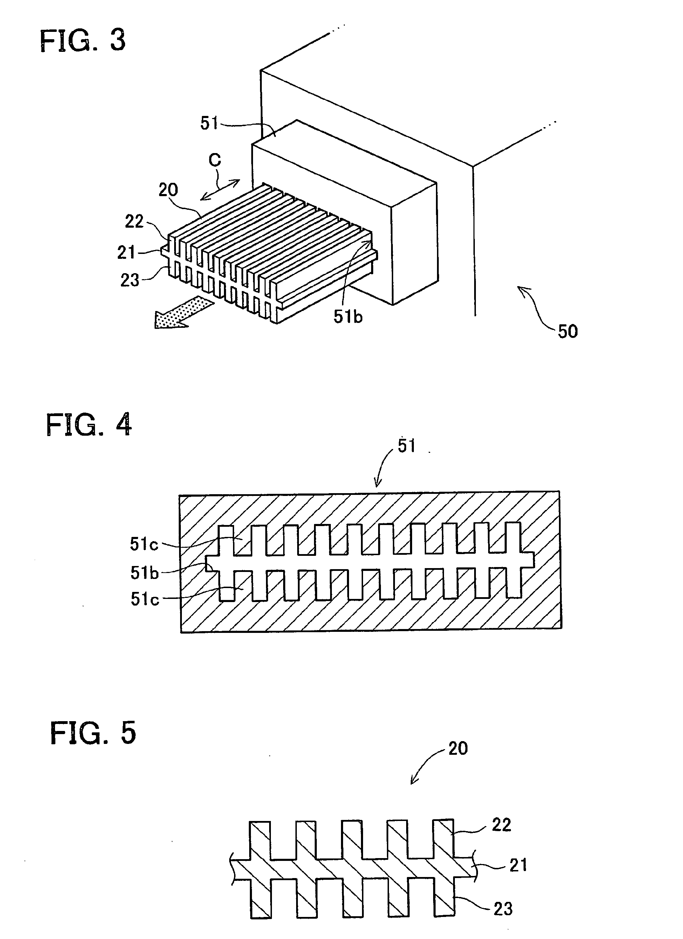

First, the fin member 20 is integrally formed by extrusion molding in an extrusion molding step. More specifically, using an extruder 50 with an extrusion mold 51 having a through hole 51b as shown in FIG. 3, heated and softened aluminum is extruded and cooled to integrally form the fin member 20. Thereby, the fin member 20 including the rectangular flat plate-shape base 21, a plurality of (ten in Example 1) front side fins 22 protruding from the front side 21b of the base 21, and a plurality of (ten in Example 1) back side fins 23 protruding from the back side 21c of the base 21 can be obtained. The through hole 51b in the extrusion mold 51 has a shape corresponding to a cross section (a cross section of the fin member 20 cut in a direction orthogonal to the fin extending direction C, see FIG. 6) of the fin member 20 as shown in FIG. 4.

The fin member 20 of such a shape can be extrusion-molded with good moldability as compared to the extrusion molding of the fin member 520 having fins 522 protruding only from the back side 521c (one side) of the base 521 (see FIG. 28). This is because, while the fin member can have equivalent cooling performance by setting the sum (H1 + H2) of the protruding height of the front side fins 22 from the base 21 and the protruding height of the back side fins 23 from the base 21 to be equal to the protruding height H of the fins 522 (with the fin thickness W being equal), the respective protruding heights H1 and H2 of the front side fins 22 and the back side fins 23 can be made lower than the protruding height H of the fins 522. In Example 1, in particular, as the fin member 20 has a shape in which the front side fins 22 and the back side fins 23 are symmetrical (vertically symmetrical in FIG. 2) with respect to the base 21, the respective protruding heights H1 and H2 of the front side fins 22 and the back side fins 23 can be reduced to half of the protruding height H of the fins 522. This enables the length of the fin-forming parts 51c of the extrusion mold 51 to be made shorter (to half of that of the extrusion mold for the fin member 520), whereby the extrusion mold 51 can have higher strength. Thereby, deformation of the extrusion mold 51 during extrusion molding is suppressed and the moldability of the fin member 20 is improved.

With the fin member 20 having such a shape as described above, warping (bending) at the time of cooling the extruded aluminum can be suppressed (see FIG. 5) as compared to the fin member 520 (see FIG. 30). This is because the fin member 20 of Example 1 has fast cooling fins (front side fins 22 and back side fins 23) arranged on both sides (front side 21b and back side 21c) of the base 21 that cools down slowly. In Example 1, in particular, the fin member 20 has a shape in which the front side fins 22 and the back side fins 23 are symmetrical (vertically symmetrical in FIG. 2) with respect to the base 21. Namely, the front side fins 22 and back side fins 23 having the same shape (and thus equal cooling speed) are arranged at symmetrical positions with respect to the base 21. This makes the cooling speed of the fin member equal on the front side 21 b and back side 21c of the base 21 so that warping (bending) of the fin member 20 can be prevented as shown in FIG. 5.

The first frame part 31 made of aluminum in a rectangular flat plate shape and the second frame part 32 made of aluminum and having a square U-shaped cross section are prepared. The second frame part 32 can be fabricated by press-forming a rectangular flat aluminum plate into a rectangular U-shape.

Next, the process proceeds to an arranging step, where, as shown in FIG. 6, the fin members 20 are arranged inside the frame 30 made by the first frame part 31 and the second frame part 32. More specifically, four fin members 20 are arranged in a row on the bottom surface 32h of the second frame part 32. More particularly, four fin members 20 are arranged in a row at regular intervals in the coolant flow direction A along the fin extending direction C, their fin extending directions C all coinciding with each other (see FIG. 1). After that, the first frame part 31 is set upon an upper end face 32d of the second frame part such as to cover the same with the first frame part 31 (see FIG. 6). At this time, the distal ends 22b of the front side fins 22 come into contact with an inner surface 31h of the first frame part 31. Brazing material (with a melting point of 600°C) is applied beforehand on the inner surface 31 h of the first frame part 31 and the upper end face 32d of the second frame part.

After that, the process proceeds to a joining step, where a combination (assembly) of the fin members 20, the first frame part 31, and the second frame part 32 assembled together in the arranging step is placed inside an electric furnace (not shown). Next, the temperature inside the electric furnace is raised to 600°C to melt the brazing material. After that, the assembly is taken out from the electric furnace and cooled down to let the brazing material harden. Thus the fin members 20, the first frame part 31, and the second frame part 32 can be joined together by brazing. The heat exchanger 10 of Example 1 is completed in this way.

Note that, in Example 1, the fin member 20 is welded (brazed in Example 1) to the first frame part 31 of the frame 30 at distal ends 22b of the front side fins 22 (see FIG. 6 and FIG. 7). That is, the distal ends 22b of the front side fins 22 are welded (brazed in Example 1) to the frame 30, but the front side 21b and the back side 21c of the base 21 are not welded to the frame 30.

Thereby, the weld surface (weld 80) can be made much smaller as compared to the case where the entire front side 521b of the base 521 is welded (e.g., brazed) to the frame 530 (see FIG. 29). This allows gas 81 generated during welding (e.g., brazing) of the frame 30 and the fin member 20 to be readily expelled from the weld 80 to the outside, whereby occurrence of voids (air pockets) in the weld 80 between the fin member 20 and the frame 30 can be suppressed. Accordingly, in the heat exchanger 10 of Example 1, heat transfer from the frame 30 to the fin member 20 can be improved.

### (Example 2)

Next, Example 2 of the present invention will be described with reference to the drawings.

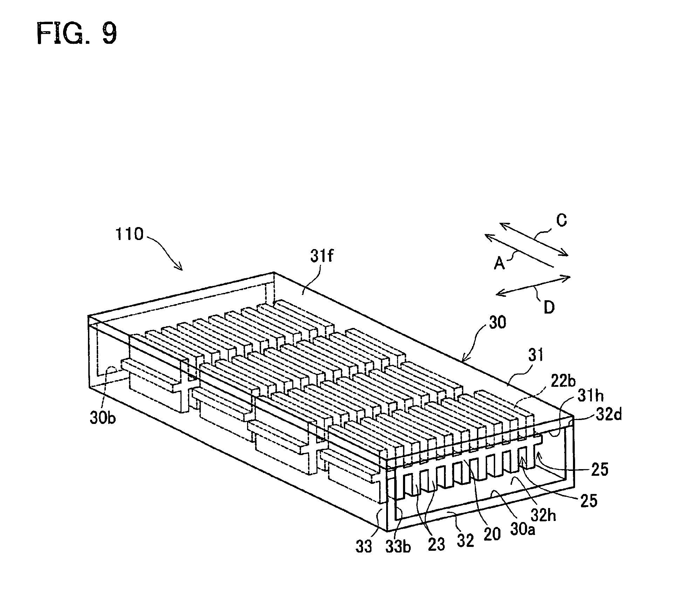

As compared to the heat exchanger 10 of Example 1, a heat exchanger 110 of Example 2 (see FIG. 9) has a different form of alignment of fin members 20, and is otherwise configured similarly. Therefore, the features different from Example 1 will mainly be described here and description of similar features will be omitted or simplified.

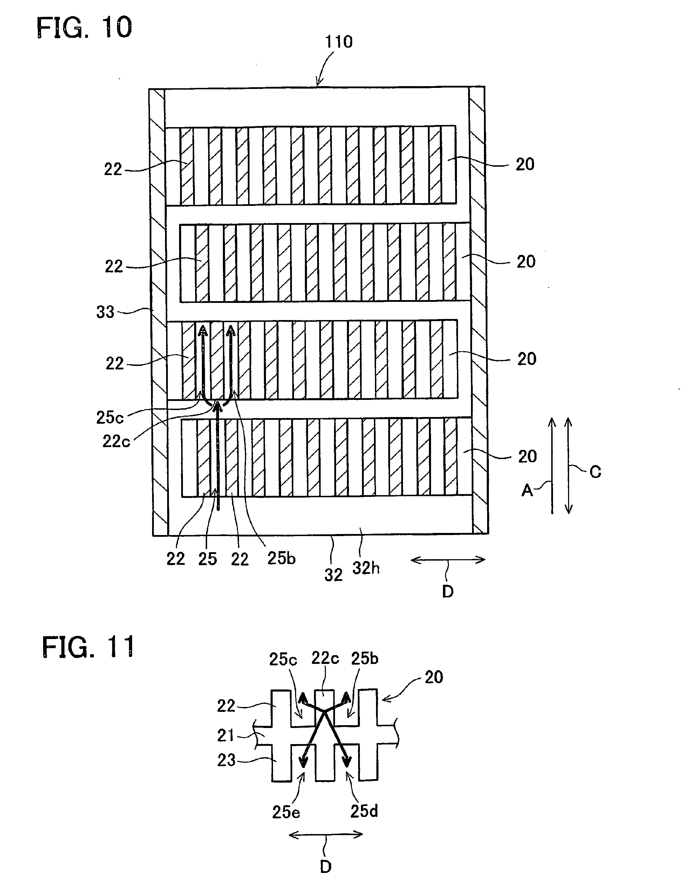

Similarly to the heat exchanger 10 of Example 1, the heat exchanger 110 of Example 2 has four fin members 20 arranged in a row at regular intervals in the coolant flow direction A along the fin extending direction C, their fin extending directions C all coinciding with each other (see FIG. 9). Unlike the heat exchanger 10 of Example 1, however, the fin members 20 adjacent to each other in the fin extending direction C (up and down direction in FIG. 10) are arranged offset from each other in the fin alignment direction D (left and right direction in FIG. 10) (see FIG. 9 and FIG. 10). FIG. 10 is a cross section of the heat exchanger 110 cut along the coolant flow direction A at a point between the first frame part 31 and the bases 21 of the fin members 20.

More particularly, the fin members 20 adjacent to each other in the fin extending direction C (adjacent to each other upstream, which is a lower side in FIG. 10, and downstream, which is an upper side in FIG. 10, of the flow channels 25 extending along the fin extending direction C) have their front side fins 22 arranged offset from each other by just half of the interval P therebetween in the fin alignment direction D (left and right direction in FIG. 10). In other words, the front side fins 22 of the fin members 20 adjacent to each other in the fin extending direction C (up and down direction in FIG. 10) are offset from each other in the fin alignment direction D. Similarly, the fin members 20 adjacent to each other in the fin extending direction C also have their back side fins 23 arranged offset from each other by just half of the interval P therebetween in the fin alignment direction D. In other words, the back side fins 23 of the fin members 20 adjacent to each other in the fin extending direction C are also offset from each other in the fin alignment direction D.

Incidentally, as a result of an investigation of the speed distribution of coolant flowing between fins in heat exchangers having fin members with plural fins that form coolant flow channels arranged inside a frame that forms an outer frame, it was found that the coolant tends to slow down as it approaches the fins. This is because the coolant is pulled toward the fins due to the effect of viscosity of the coolant. Because of this, there is created a region where the coolant speed is slower or the coolant substantially stagnates as compared to other regions (hereinafter referred to also as "interface layer") near the fins. Once this interface layer is created, the fins in which heat has been collected exchange heat only with the coolant present in the interface layer primarily formed around the fins and hardly exchange heat with coolant flowing in regions other than the interface layer. This resulted in the problem that a high cooling effect was not achieved due to the lack of efficient heat exchange with coolant flowing inside the heat exchanger.

In this respect, in the heat exchanger 110 of Example 2, as described above, the front side fins 22 of the fin members 20 adjacent to each other in the fin extending direction C are offset from each other by just half of the interval P therebetween in the fin alignment direction D (left and right direction in FIG. 10). Similarly, the back side fins 23 of the fin members 20 adjacent to each other in the fin extending direction C are also offset from each other by just half of the interval P therebetween in the fin alignment direction D.

Thereby, as indicated by arrows in FIG. 10 and FIG. 11, the coolant flowing through flow channels 25 on the front side 21b of the base 21 of a fin member 20 is made to collide the end face 22c on the upstream side of the front side fin 22 of a fin member 20 located downstream (upper side in FIG. 10) and split into two flow channels 25b and 25c bifurcated by the front side fin 22 (two flow channels 25b and 25c adjacent to each other in the fin alignment direction D via a front side fin 22) and flow channels 25d and 25e located on the back side 21c of the base 21 (see FIG. 11). This creates turbulence in the coolant flow and effectively suppresses formation of the interface layer. For the coolant flowing through flow channels 25 on the back side 21c) of the base 21 of the fin member 20, similarly to the coolant flowing through flow channels 25 on the front side 21b of the base 21, turbulence may be created in the coolant flow to effectively suppress formation of the interface layer. This enables efficient use of the coolant flowing inside the heat exchanger 110, whereby a high cooling effect can be achieved.

Next, a manufacturing method of the heat exchanger 110 according to Example 2 will be described.

First, as with Example 1, the fin member 20 is integrally formed by extrusion molding in an extrusion molding step (see FIG. 3). As with Example 1, the first frame part 31 made of aluminum in a rectangular flat plate shape and the second frame part 32 made of aluminum and having a square U-shaped cross section are prepared.

Next, the process proceeds to an arranging step, where, as shown in FIG. 9 and FIG. 10, the fin members 20 are arranged inside the frame 30 made by the first frame part 31 and the second frame part 32. More specifically, four fin members 20 are arranged in a row on the bottom surface 32h of the second frame part 32. More particularly, four fin members 20 are arranged in a row at regular intervals in the coolant flow direction A along the fin extending direction C, their fin extending directions C all coinciding with each other (see FIG. 9 and FIG. 10).

Note, however, the fin members 20 adjacent to each other in the fin extending direction C (up and down direction in FIG. 10) are arranged offset from each other in the fin alignment direction D (left and right direction in FIG. 10) (see FIG. 9 and FIG. 10). More particularly, the four fin members 20 are aligned in the fin extending direction C such that the front side fins 22 and back side fins 23 of the fin members 20 adjacent to each other in the fin extending direction C are offset from each other by just half of the interval P therebetween in the fin alignment direction D (left and right direction in FIG. 10). After that, the first frame part 31 is set upon an upper end face 32d of the second frame part such as to cover the same with the first frame part 31 (see FIG. 9). At this time, the distal ends 22b of the front side fins 22 come into contact with an inner surface 31h of the first frame part 31. Brazing material (with a melting point of 600°C) is applied beforehand on the inner surface 31h of the first frame part 31 and the upper end face 32d of the second frame part.

After that, the process proceeds to a joining step, where the fin members 20, the first frame part 31, and the second frame part 32 are joined together by brazing, as with Example 1. The heat exchanger 110 of Example 2 is completed in this way.

The heat exchanger 110 of Example 2 can be used for cooling semiconductor elements as with the heat exchanger 10 of Example 1. More specifically, for example, a semiconductor device is configured by arranging semiconductor elements 71 to 74 via insulating plates 60 (see FIG. 8) on an outer surface 31f of the first frame part 31. Thereby, the semiconductor elements 71 to 74 can be cooled by the heat exchanger 110.

### (Example 3)

Next, Example 3 of the present invention will be described with reference to the drawings.

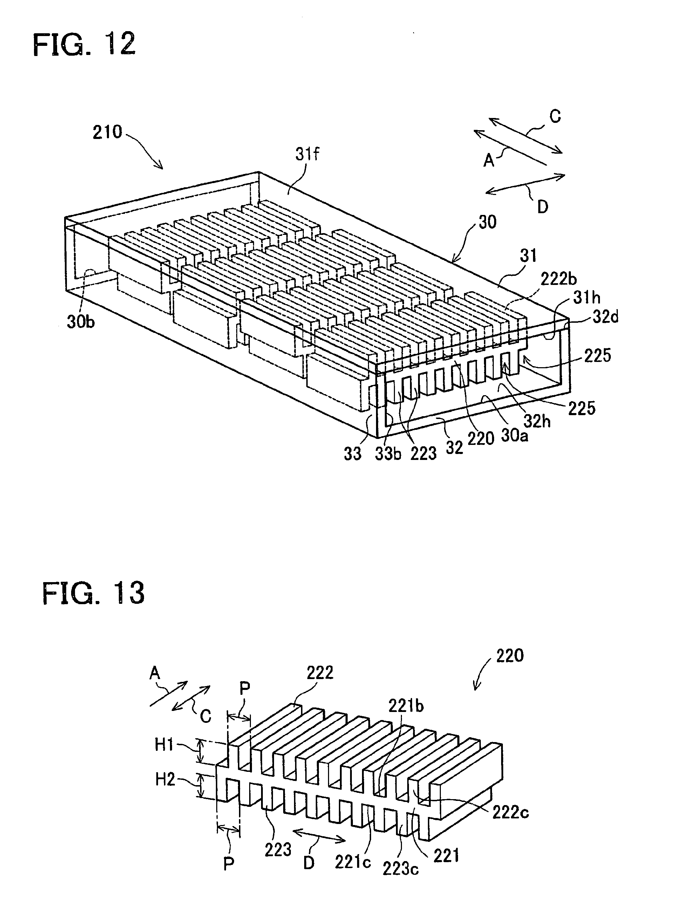

As compared to the heat exchanger 10 of Example 1, a heat exchanger 210 of Example 3 (see FIG. 12) has different fin members and form of alignment thereof, and is otherwise configured similarly. Therefore, the features different from Example 1 will mainly be described here and description of similar features will be omitted or simplified.

The fin member 220 of Example 3 is made of aluminum and includes a base 221 in a rectangular flat plate shape, a plurality of (ten in Example 3) front side fins 222 protruding from a front side 221b of the base 221, and a plurality of (ten in Example 3) back side fins 223 protruding from a back side 221c of the base 221 (see FIG. 13). This fin member 220 is integrally formed by extrusion molding as with the fin member 20 of Example 1.

Note, however, unlike the fin member 20 of Example 1, this fin member 220 has its front side fins 222 and back side fins 223 arranged offset from each other by just half of the interval P therebetween in the fin alignment direction D as shown in FIG. 13.

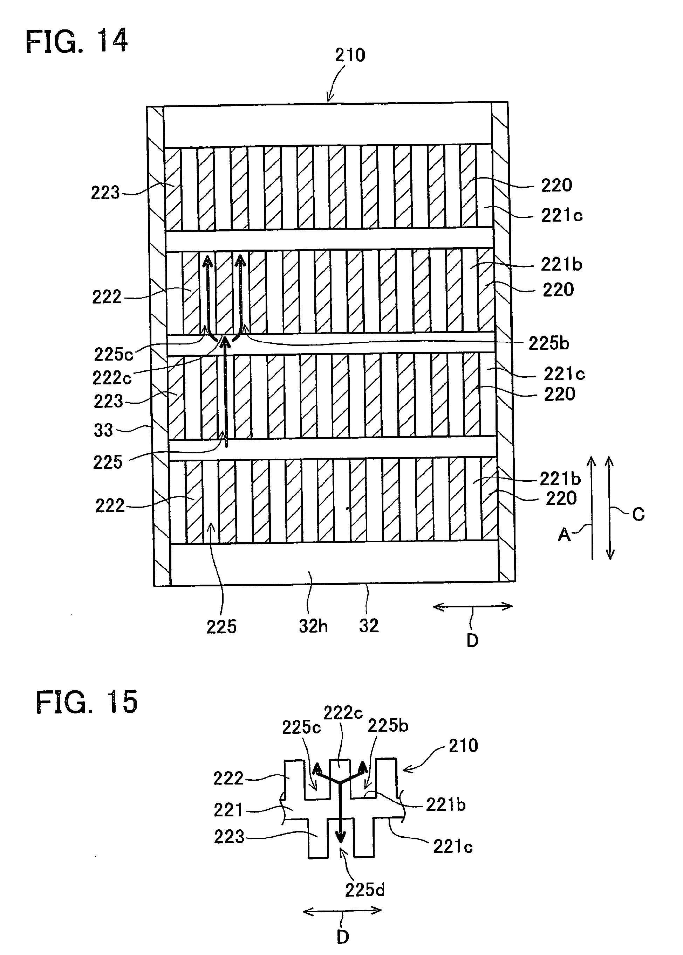

In the heat exchanger 210 of Example 3, the fin members 220 of the above-described form are aligned straight in a row in the coolant flow direction A (fin extending direction C), with the front sides 221b and the back sides 221c of the bases 221 oriented alternately oppositely (see FIG. 12 and FIG. 14). Thereby, the front side fins 222 and back side fins 223 of the fin members 220 adjacent to each other in the fin extending direction C (up and down direction in FIG. 14) can be arranged offset from each other by just half of the interval P therebetween in the fin alignment direction D (left and right direction in FIG. 14). FIG. 14 is a cross section of the heat exchanger 210 cut along the coolant flow direction A at a point between the first frame part 31 and the bases 221 of the fin members 220.

Thereby, as indicated by arrows in FIG. 14 and FIG. 15, the coolant flowing through flow channels 225 on the back side 221c of the base 221 of a fin member 220 is made to collide the end face 222c on the upstream side of the front side fin 222 of a fin member 220 located downstream (upper side in FIG. 14) and split into two flow channels 225b and 225c bifurcated by the front side fin 222 (two flow channels 225b and 225c adjacent to each other in the fin alignment direction D via a front side fin 222) and a flow channel 225d located on the back side 221c of the base 221 (see FIG. 15). This creates turbulence in the coolant flow and effectively suppresses formation of the interface layer. For the coolant flowing through the flow channels 225 on the front side 221 b of the base 221 of the fin member 220, similarly to the coolant flowing through the flow channels 225 on the back side 221c of the base 221, turbulence may be created in the coolant flow to effectively suppress formation of the interface layer. This enables efficient use of the coolant flowing inside the heat exchanger 210, whereby a high cooling effect can be achieved.

Moreover, in the fin member 220 of Example 3, back side fins 223 are not present at the symmetrically opposite positions of the front side fins 222 (directly below in FIG. 13 and FIG. 15) with respect to the base 221, and further, front side fins 222 are not present at the symmetrically opposite positions of the back side fins 223 (directly above in FIG. 13 and FIG. 15) with respect to the base 221. Therefore, as compared to a heat exchanger (e.g., heat exchanger 110 of Example 2) using a fin member (e.g., fin member 20) in which back side fins are present at symmetrical positions of the front side fins with respect to the base, the coolant flowing through the flow channels 225 (e.g., flow channels 225 on the back side 221c of the base 221 of the fin member 220) can be readily split into the flow channels 225 located on the opposite side (e.g., back side 221c) of the base 221 when it collides the end face on the upstream side of the fin member 220 (e.g., end face 222c on the upstream side of the front side fin 222) located downstream. This promotes creation of turbulence in the coolant thereby to further suppress formation of the interface layer.

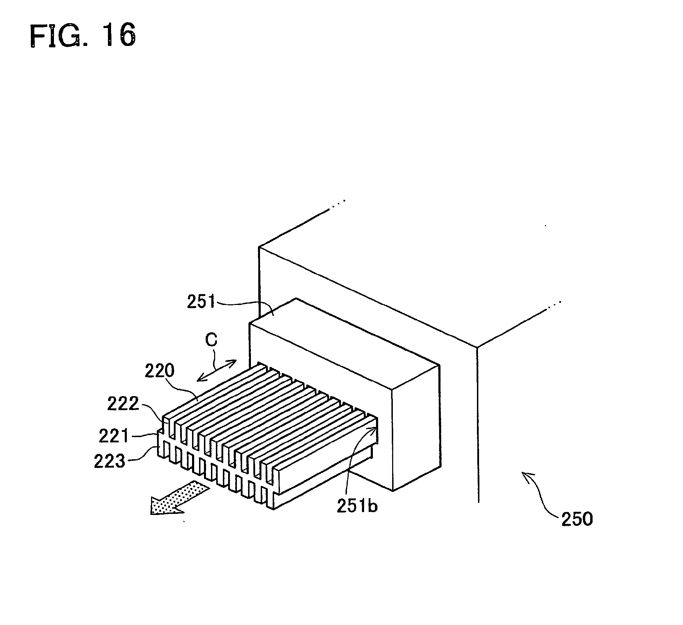

Since the fin member 220 of Example 3 has the front side fins 222 and the back side fins 223, as with the fin member 20 of Example 1, it has good moldability of extrusion molding as compared to the fin member 520 having fins 522 protruding only from the back side 521c (one side) of the base 521 (see FIG. 28). This is because, the extrusion mold 251 used for molding the fin member 220 (particularly, part of the extrusion mold 251 that forms the fins, see FIG. 16) can have higher strength, whereby deformation of the extrusion mold 251 during extrusion molding is suppressed.

Further, the fin member 220 of Example 3 is a fin member less liable to warp (bend) as compared to the fin member 520 (see FIG. 30). Namely, warping (bending) can be suppressed at the time of cooling the extrusion-molded fin member, as compared to the fin member 520 (see FIG. 30). This is because the fin member 220 has fast cooling fins (front side fins 222 and back side fins 223) arranged on both sides (front side 221b and back side 221 c) of the base 221 that cools down slowly. This reduces the difference in how fast the fin member cools down (cooling speed) between the front side 221b and the back side 221c of the base 221, whereby warping (bending) of the fin member can be suppressed.

Further, in the heat exchanger 210 of Example 3, the fin member 220 is welded (brazed) to the first frame part 31 of the frame 30 at distal ends 222b of the front side fins 222. That is, the distal ends 222b of the front side fins 222 are welded (brazed) to the frame 30, but the front side 221 b and the back side 221c of the base 221 are not welded to the frame 30. This allows gas generated during welding (e.g., brazing) of the frame 30 and the fin member 220 to be readily expelled from the weld to the outside, whereby occurrence of voids (air pockets) in the weld between the fin member 220 and the frame 30 can be suppressed.

Next, a manufacturing method of the heat exchanger 210 according to Example 3 will be described.

First, the fin member 220 is integrally formed by extrusion molding in an extrusion molding step. More specifically, using an extruder 250 with an extrusion mold 251 having a through hole 251b as shown in FIG. 16, heated and softened aluminum is extruded and cooled to integrally form the fin member 220. Thereby, the fin member 220 can be obtained, wherein the interval P between the front side fins 222 and the interval P between the back side fins 223 are equal and regular in the fin alignment direction D, the front side fins 222 and back side fins 223 arranged offset from each other by just half of the pitch P in the fin alignment direction D (see FIG. 13). The through hole 251 b in the extrusion mold 251 has a shape corresponding to a cross section (a cross section of the fin member 220 cut in a direction orthogonal to the fin extending direction C) of the fin member 220.

Similarly to Example 1, the first frame part 31 made of aluminum in a rectangular flat plate shape and the second frame part 32 made of aluminum and having a square U-shaped cross section are prepared.

Next, the process proceeds to an arranging step, where, as shown in FIG. 12 and FIG. 14, the fin members 220 are arranged inside the frame 30 made by the first frame part 31 and second frame part 32. More specifically, four fin members 220 are arranged in a row on the bottom surface 32h of the second frame part 32. More particularly, four fin members 220 are arranged in a row at regular intervals in the coolant flow direction A along the fin extending direction C, their fin extending directions C all coinciding with each other (see FIG. 12 and FIG. 14).

The four fin members 220, however, are aligned straight in a row in the coolant flow direction A (fin extending direction C) such that the front sides 221b and the back sides 221c of the bases 221 are oriented alternately oppositely (see FIG. 12 and FIG. 14). Thereby, the front side fins 222 and back side fins 223 of the fin members 220 adjacent to each other in the fin extending direction C (up and down direction in FIG. 14) can be arranged offset from each other by just half of the interval P therebetween in the fin alignment direction D (left and right direction in FIG. 14).

After that, the first frame part 31 is set upon an upper end face 32d of the second frame part such as to cover the same with the first frame part 31 (see FIG. 12). At this time, the distal ends 222b of the front side fins 222 come into contact with an inner surface 31 h of the first frame part 31. Brazing material (with a melting point of 600°C) is applied beforehand on the inner surface 31h of the first frame part 31 and the upper end face 32d of the second frame part. After that, the process proceeds to a joining step, where the fin members 220, the first frame part 31, and the second frame part 32 are joined together by brazing as with Example 1. The heat exchanger 210 of Example 3 is completed in this way.

The heat exchanger 210 of Example 3 can be used for cooling semiconductor elements as with the heat exchanger 10 of Example 1. More specifically, for example, a semiconductor device is configured by arranging semiconductor elements 71 to 74 via insulating plates 60 (see FIG. 8) on an outer surface 31f of the first frame part 31. Thereby, the semiconductor elements 71 to 74 can be cooled by the heat exchanger 210.

### (Example 4)

Next, Example 4 of the present invention will be described with reference to the drawings.

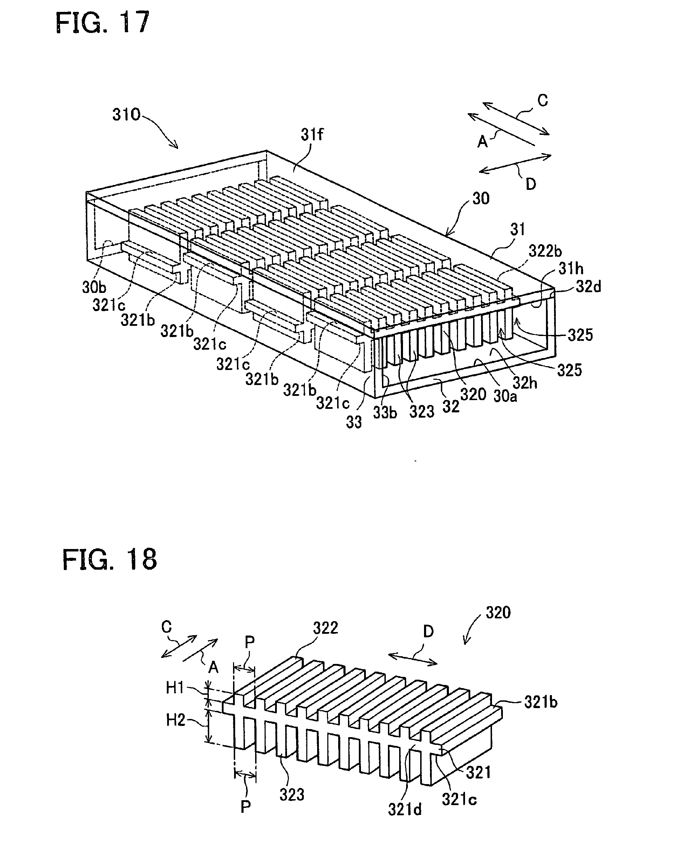

As compared to the heat exchanger 10 of Example 1, a heat exchanger 310 of Example 4 has different fin members and form of alignment thereof, and is otherwise configured similarly (see FIG. 17). Therefore, the features different from Example 1 will mainly be described here and description of similar features will be omitted or simplified.

The fin member 320 of Example 4 is made of aluminum and includes a base 321 in a rectangular flat plate shape, a plurality of (ten in Example 4) front side fins 322 protruding from a front side 321b of the base 321, and a plurality of (ten in Example 4) back side fins 323 protruding from a back side 321c of the base 321 (see FIG. 18). This fin member 320 is integrally formed by extrusion molding as with the fin member 20 of Example 1.

This fin member 320 is different from the fin member 20 of Example 1, as shown in FIG. 18, only in that the protruding height H1 of the front side fins 322 is different from the protruding height H2 of the back side fins 323 (H1 < H2).

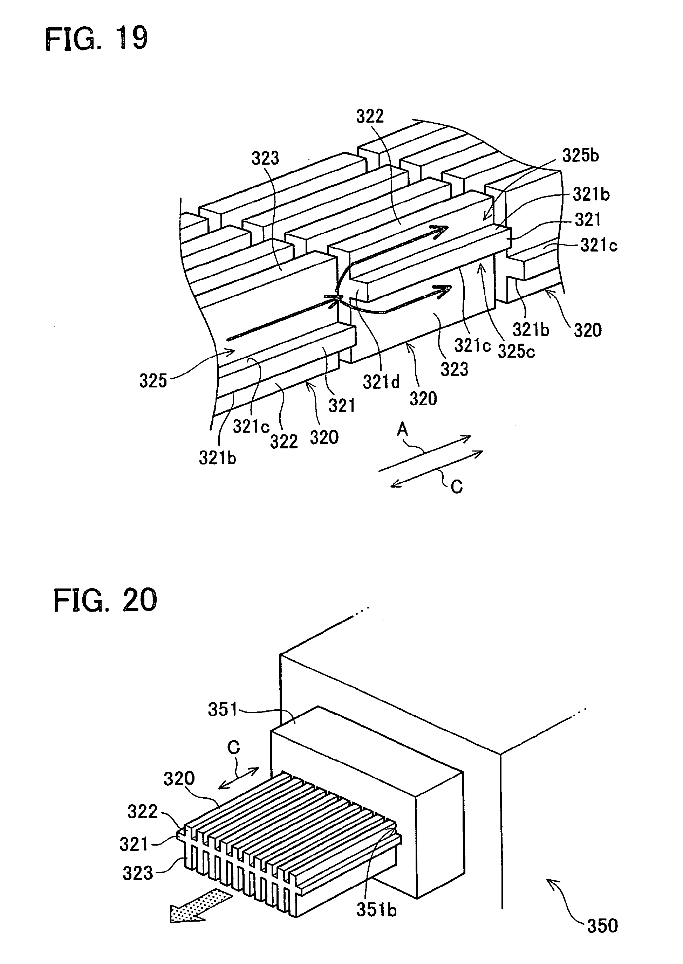

In the heat exchanger 310 of Example 4, the fin members 320 of the above-described form are aligned in a row in the coolant flow direction A (fin extending direction C), with the front sides 321b and the back sides 321c of the bases 321 oriented alternately oppositely (see FIG. 17 and FIG. 19). Thereby, the bases 321 of the fin members 320 adjacent to each other in the fin extending direction C can be offset from each other. More particularly, the bases 321 of the fin members 320 adjacent to each other in the fin extending direction C can be arranged offset from each other in a direction orthogonal to the front side 321b of the base 321 (up and down direction in FIG. 17 and FIG. 19). FIG. 19 is an enlarged view of part of the plurality of fin members 320 aligned in FIG. 17.

Thereby, as indicated by arrows in FIG. 19, the coolant flowing through flow channels 325 is made to collide the end face 321d on the upstream side of the base 321 of a fin member 320 located on a downstream side (on an obliquely right upper side in FIG. 19) and split into two flow channels 325b and 325c located on the front side 321b and back side 321c of the base 321. This promotes creation of turbulence in the coolant and suppresses formation of the interface layer. This enables efficient use of the coolant flowing inside the heat exchanger 310, whereby a high cooling effect can be achieved.

Since the fin member 320 of Example 4 has the front side fins 322 and the back side fins 323, it has good moldability of extrusion molding as compared to the fin member 520 having fins 522 protruding only from the back side 521c (one side) of the base 521 (see FIG. 28). This is because, the extrusion mold 351 used for molding the fin member 320 (particularly, part of the extrusion mold 351 that forms the fins, see FIG. 20) can have higher strength, whereby deformation of the extrusion mold 351 during extrusion molding is suppressed.

Further, the fin member 320 of Example 4 is a fin member less liable to warp (bend) as compared to the fin member 520 (see FIG. 30). Namely, warping (bending) can be suppressed at the time of cooling the extrusion-molded fin member, as compared to the fin member 520 (see FIG. 30). This is because the fin member 320 has fast cooling fins (front side fins 322 and back side fins 323) arranged on both sides (front side 321b and back side 321c) of the base 321 that cools down slowly. This reduces the difference in how fast the fin member cools down (cooling speed) between the front side 321b and the back side 321c of the base 321, whereby warping (bending) of the fin member can be suppressed.

Further, in the heat exchanger 310 of Example 4, the fin member 320 is welded (brazed) to the first frame part 31 of the frame 30 at distal ends 322b of the front side fins 322. That is, the distal ends 322b of the front side fins 322 are welded (brazed) to the frame 30, but the front side 321b and the back side 321c of the base 321 are not welded to the frame 30. This allows gas generated during welding (e.g., brazing) of the frame 30 and the fin member 320 to be readily expelled from the weld to the outside, whereby occurrence of voids (air pockets) in the weld between the fin member 320 and the frame 30 can be suppressed.

Next, a manufacturing method of the heat exchanger 310 according to Example 4 will be described.

First, the fin member 320 is integrally formed by extrusion molding in an extrusion molding step. More specifically, using an extruder 350 with an extrusion mold 351 having a through hole 351b as shown in FIG. 20, heated and softened aluminum is extruded and cooled to integrally form the fin member 320. Thereby, the fin member 320 (see FIG. 18) can be obtained, wherein the interval P between the front side fins 322 and the interval P between the back side fins 323 are equal and regular in the fin alignment direction D, and the protruding height H1 of the front side fins 322 is different from the protruding height H2 of the back side fins 323 (H1 < H2). The through hole 351b in the extrusion mold 351 has a shape corresponding to a cross section (a cross section of the fin member 320 cut in a direction orthogonal to the fin extending direction C) of the fin member 320.

Similarly to Example 1, the first frame part 31 made of aluminum in a rectangular flat plate shape and the second frame part 32 made of aluminum and having a square U-shaped cross section are prepared.

Next, the process proceeds to an arranging step, where, as shown in FIG. 17, the fin members 320 are arranged inside the frame 30 made by the first frame part 31 and the second frame part 32. More specifically, four fin members 320 are arranged in a row on the bottom surface 32h of the second frame part 32. More particularly, four fin members 320 are arranged in a row at regular intervals in the coolant flow direction A along the fin extending direction C, their fin extending directions C all coinciding with each other (see FIG. 17).

The fin members 320, however, are aligned in a row in the coolant flow direction A (fin extending direction C) such that the front sides 321b and the back sides 321c of the bases 321 are oriented alternately oppositely (see FIG. 17 and FIG. 19). Thereby, the bases 321 of the fin members 320 adjacent to each other in the fin extending direction C can be offset from each other. More particularly, the bases 321 of the fin members 320 adjacent to each other in the fin extending direction C can be arranged offset from each other in a direction orthogonal to the front side 321b of the base 321 (up and down direction in FIG. 17 and FIG. 19).

After that, the first frame part 31 is set upon an upper end face 32d of the second frame part such as to cover the same with the first frame part 31 (see FIG. 17). At this time, the distal ends 322b of the front side fins 322 come into contact with an inner surface 31h of the first frame part 31. Brazing material (with a melting point of 600°C) is applied beforehand on the inner surface 31h of the first frame part 31 and the upper end face 32d of the second frame part. After that, the process proceeds to a joining step, where the fin members 320, the first frame part 31, and the second frame part 32 are joined together by brazing as with Example 1. The heat exchanger 310 of Example 4 is completed in this way.

The heat exchanger 310 of Example 4 can be used for cooling semiconductor elements as with the heat exchanger 10 of Example 1. More specifically, for example, a semiconductor device is configured by arranging semiconductor elements 71 to 74 via insulating plates 60 (see FIG. 8) on an outer surface 31f of the first frame part 31. Thereby, the semiconductor elements 71 to 74 can be cooled by the heat exchanger 310.

### (Example 5)

Next, Example 5 of the present invention will be described with reference to the drawings.

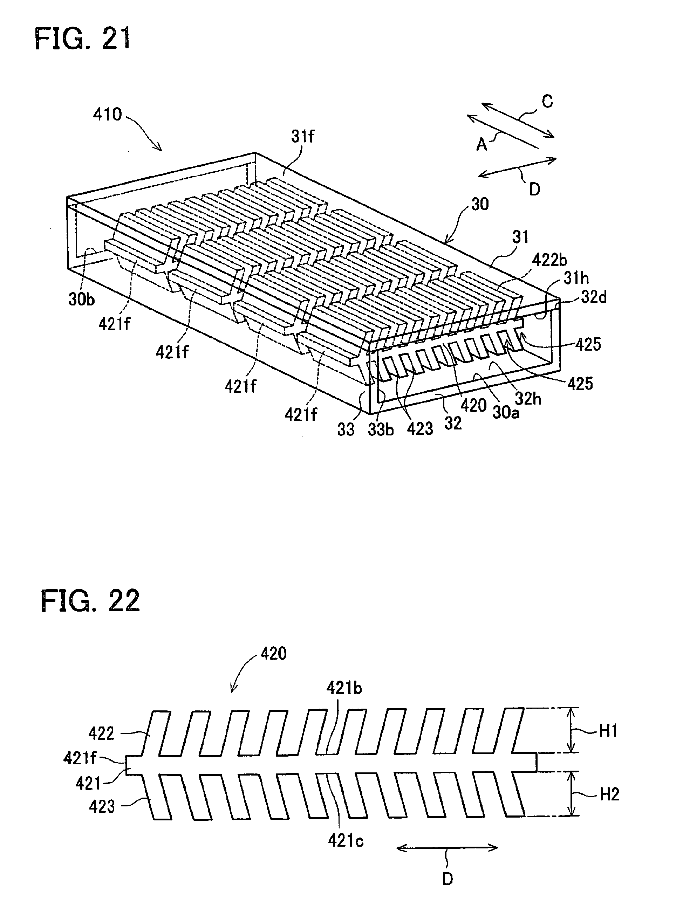

As compared to the heat exchanger 10 of Example 1, a heat exchanger 410 of Example 5 (see FIG. 21) has different fin members, and is otherwise configured similarly. Therefore, the features different from Example 1 will mainly be described here and description of similar features will be omitted or simplified.

The fin member 420 of Example 5 is made of aluminum and includes a base 421 in a rectangular flat plate shape, a plurality of (ten in Example 5) front side fins 422 protruding from a front side 421b of the base 421, and a plurality of (ten in Example 5) back side fins 423 protruding from a back side 421c of the base 421 (see FIG. 22). This fin member 420 is integrally formed by extrusion molding as with the fin member 20 of Example 1.

This fin member 420 is different from the fin member 20 of Example 1, as shown in FIG. 22, in that the front side fins 422 and the back side fins 423 protrude obliquely toward the same side in the fin alignment direction D (right side in FIG. 22). More specifically, the front side fins 422 protrude in an oblique direction (obliquely right-upward in FIG. 22) relative to a direction orthogonal to the front side 421b of the base 421 (vertically upward in FIG. 22). The back side fins 423 protrude in an oblique direction (obliquely right-downward in FIG. 22) relative to a direction orthogonal to the back side 421c of the base 421 (vertically downward in FIG. 22). While the protruding height H1 of the front side fins 422 and the protruding height H2 of the back side fins 423 are equal to each other, they are slightly higher than the protruding heights H1 and H2 of the fin member 20 of Example 1.

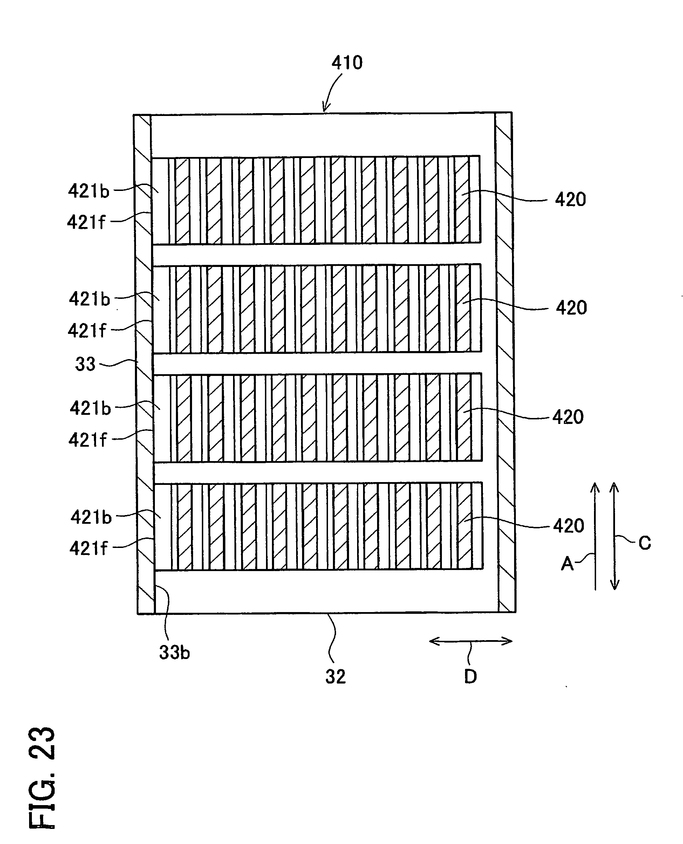

In the heat exchanger 410 of Example 5, a plurality of (four in Example 5, too) fin members 420 are arranged relative to each other such that the front side fins 422 and the back side fins 423 are inclined toward the same side (see FIG. 21). One end face 421f in the fin alignment direction D of the base 421 of respective fin members 420 is abutted on a flat inner wall surface 33b of one side wall 33 in the fin alignment direction D of the second frame part 32 (see FIG. 21 and FIG. 23).

Thereby, the plurality of fin members 420 arranged in a row in the coolant flow direction A (upward in FIG. 23) are aligned straight in a row along the flat inner wall surface 33b of one side wall 33 of the second frame part 32. Accordingly, the plurality of fin members 420 are aligned straight in a row in the coolant flow direction A without being displaced from each other in the fin alignment direction D (left and right direction in FIG. 23). FIG. 23 is a cross section of the heat exchanger 410 cut along the coolant flow direction A at a midway point between the first frame part 31 and the bases 421 of the fin members 420.

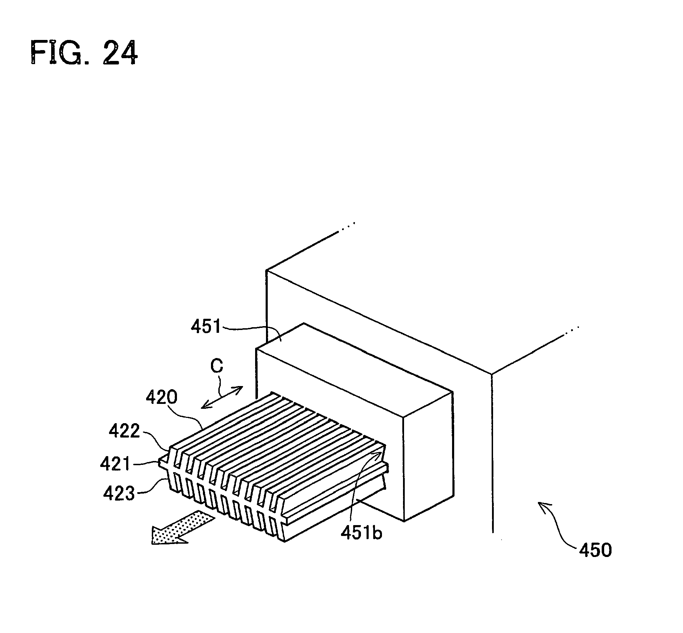

Since the fin member 420 of Example 5 has the front side fins 422 and the back side fins 423, it has good moldability of extrusion molding as compared to the fin member 520 having fins 522 protruding only from the back side 521c (one side) of the base 521 (see FIG. 28). This is because, the extrusion mold 451 used for molding the fin member 420 (particularly, part of the extrusion mold 451 that forms the fins, see FIG. 24) can have higher strength, whereby deformation of the extrusion mold 451 during extrusion molding is suppressed.

Further, the fin member 420 of Example 5 is a fin member less liable to warp (bend) as compared to the fin member 520 (see FIG. 30). Namely, warping (bending) can be suppressed at the time of cooling the extrusion-molded fin member, as compared to the fin member 520 (see FIG. 30). This is because the fin member 420 has fast cooling fins (front side fins 422 and back side fins 423) arranged on both sides (front side 421 b and back side 421 c) of the base 421 that cools down slowly. This reduces the difference in how fast the fin member cools down (cooling speed) between the front side 421b and back side 421c of the base 421, whereby warping (bending) of the fin member can be suppressed.

Further, in the heat exchanger 410 of Example 5, the fin member 420 is welded (brazed) to the first frame part 31 of the frame 30 at distal ends 422b of the front side fins 422. That is, the distal ends 422b of the front side fins 422 are welded (brazed) to the frame 30, but the front side 421b and the back side 421c of the base 421 are not welded to the frame 30. This allows gas generated during welding (e.g., brazing) of the frame 30 and the fin member 420 to be readily expelled from the weld to the outside, whereby occurrence of voids (air pockets) in the weld between the fin member 420 and the frame 30 can be suppressed.

Next, a manufacturing method of the heat exchanger 410 according to Example 5 will be described.

First, the fin member 420 is integrally formed by extrusion molding in an extrusion molding step. More specifically, using an extruder 450 with an extrusion mold 451 having a through hole 451b as shown in FIG. 24, heated and softened aluminum is extruded and cooled to integrally form the fin member 420. Thereby, the fin member 420 (see FIG. 22) having front side fins 422 and back side fins 423 protruding obliquely toward the same side in the fin alignment direction D can be obtained. The through hole 451b in the extrusion mold 451 has a shape corresponding to a cross section (a cross section of the fin member 420 cut in a direction orthogonal to the fin extending direction C) of the fin member 420.

Similarly to Example 1, the first frame part 31 made of aluminum in a rectangular flat plate shape and the second frame part 32 made of aluminum and having a square U-shaped cross section are prepared.

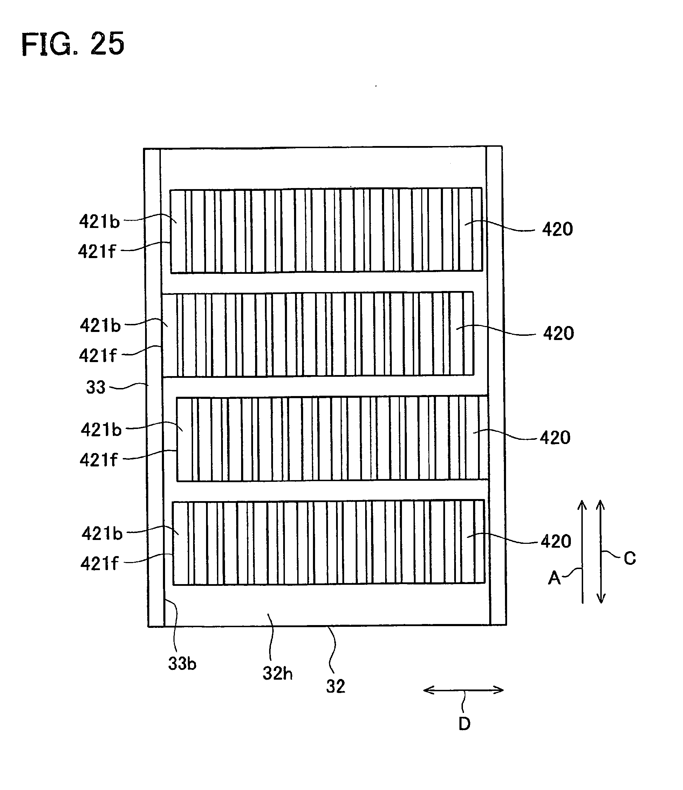

Next, the process proceeds to an arranging step, where, as shown in FIG. 25, four fin members 420 are arranged in a row on the bottom surface 32h of the second frame part 32. More particularly, four fin members 420 are arranged in a row at regular intervals in the coolant flow direction A along the fin extending direction C, their fin extending directions C all coinciding with each other.

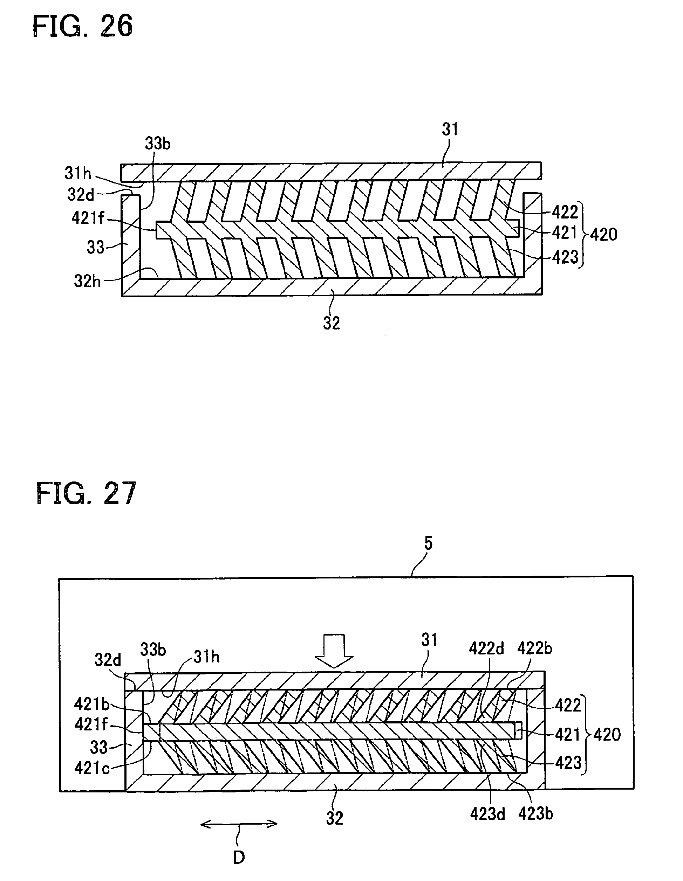

After that, the first frame part 31 is set upon the fin members 420 such as to cover the second frame part 32 with the first frame part 31 (see FIG. 26). At this time, the first frame part 31 does not contact the upper end face 32d of the second frame part but is arranged thereabove, separated from the upper end face 32d of the second frame part. This is because the fin member 420 of Example 5 has the front side fins 422 and the back side fins 423 whose protruding heights H1 and H2, respectively, are slightly higher than the protruding heights H1 and H2 of the fin members 20 of Example 1. Brazing material (with a melting point of 600°C) is applied beforehand on the inner surface 31h of the first frame part 31 and the upper end face 32d of the second frame part.

Incidentally, the fin members 420 and the second frame part 32 include dimensional tolerance decided at the design stage and dimensional errors or the like caused during the production process. Therefore, in the arranging step, when the four fin members 420 are arranged in a row on the bottom surface 32h of the second frame part 32, the four fin members 420 would sometimes be displaced in the fin alignment direction D (left and right direction in FIG. 25) as shown in FIG. 25. FIG. 25 is a top plan view of the four fin members 420 arranged in a row on the bottom surface 32h of the second frame part 32.

In this respect, in Example 5, as shown in FIG. 27, the first frame part 31 is pressed toward the fin member 420 side (downward in FIG. 27) with a pressing jig (not shown) inside the electric furnace 5 in the joining step so that the fin members 420, the first frame part 31, and the second frame part 32 are joined together by brazing in a state where the inner surface 31h of the first frame part 31 is contacted to the upper end face 32d of the second frame part 32. By pressing the first frame part 31 toward the fin member 420 side (downward in FIG. 27), with respect to the four fin members 420 located inside the second frame part 32, the distal ends 422b of the front side fins 422 can be pressed toward the front side 42 1 b of the base 421 (downward in FIG. 27) through the first frame part 31, as well as the distal ends 423b of the back side fins 423 can be pressed toward the back side 421c of the base 421 (upward in FIG. 27) through the second frame part 32.

Thereby, the front side fins 422 and the back side fins 423 are compressed and deformed so that the base ends 422d of the front side fins 422 and the base ends 423d of the back side fins 423 can be moved toward the opposite side from the side toward which the front side fins 422 and the back side fins 423 are inclined (left side in FIG. 27) in the fin alignment direction D. Thereby, the base 421 is moved toward the opposite side from the side toward which the front side fins 422 and the back side fins 423 are inclined (left side in FIG. 27) in the fin alignment direction D, to cause one end face 421f in the fin alignment direction D of the base 421 (more particularly, the opposite side in the fin alignment direction D from the side toward which the front side fins 422 and the back side fins 423 are inclined) to abut on the flat inner wall surface 33b of one side wall 33 of the second frame part 32 in the fin alignment direction D (more particularly, the opposite side in the fin alignment direction D from the side toward which the front side fins 422 and the back side fins 423 are inclined).

Thus the four fin members 420 arranged in a row in the coolant flow direction A can be aligned straight in a row along the flat inner wall surface 33b of one side wall 33 of the second frame part 32. In this state, the temperature inside the electric furnace 5 is raised to 600°C to melt the brazing material after which the brazing material is cooled down to be hardened. Thus the fin members 420, the first frame part 31, and the second frame part 32 can be joined together by brazing. "The heat exchanger 410 (see FIG. 21) with a plurality of fin members 420 aligned straight in a row in the coolant flow direction A without being displaced in the fin alignment direction D" is completed in this way.

The heat exchanger 410 of Example 5 can be used for cooling semiconductor elements as with the heat exchanger 10 of Example 1. More specifically, for example, a semiconductor device is configured by arranging semiconductor elements 71 to 74 via insulating plates 60 (see FIG. 8) on an outer surface 31f of the first frame part 31. Thereby, the semiconductor elements 71 to 74 can be cooled by the heat exchanger 410.

While the present invention has been described above with respect to Examples 1 to 5, it will be appreciated that the present invention is not restricted to the above Examples and can be applied by making suitable changes without departing from the scope thereof.

For example, in the heat exchanger 310 of Example 4, the fin members 320 are aligned straight in a row in the coolant flow direction A (fin extending direction C) with the front sides 321b and the back sides 321c of the bases 321 oriented alternately oppositely (see FIG. 17 and FIG. 19).

Instead, the fin members 320 adjacent to each other in the fin extending direction C may be arranged offset from each other in the fin alignment direction D as with Example 2. More particularly, the front side fins 322 of fin members 320 adjacent to each other in the fin extending direction C may be arranged offset from each other by just half of the interval P therebetween in the fin alignment direction D, as well as the back side fins 323 of fin members 320 adjacent to each other in the fin extending direction C may be arranged offset from each other by just half of the interval P therebetween in the fin alignment direction D. Thereby, the coolant turbulence effect of Example 2 can be achieved in addition to the coolant turbulence effect of Example 4, whereby more turbulence is created in the coolant flow to further suppress formation of the interface layer.

Alternatively, the fin member 320 may have a form wherein the front side fins 322 and the back side fins 323 have different protruding heights H1 and H2, respectively, (H1 < H2), and in addition, as with the fin member 220 of Example 3, the front side fins 322 and the back side fins 323 are arranged offset from each other by just half of the interval P therebetween in the fin alignment direction D. Thereby, the coolant turbulence effect of Example 3 can be achieved in addition to the coolant turbulence effect of Example 4, whereby more turbulence is created in the coolant flow to further suppress formation of the interface layer.

### DESCRIPTION OF THE REFERENCE SIGNS

- 10, 110, 210, 310, 410: Heat exchanger
- 20, 220, 320, 420: Fin member
- 21, 221, 321, 421: Base
- 21b, 221b, 321b, 421b: Front side of base
- 21c, 221c, 321c, 421c: Back side of base
- 22, 222, 322, 422: Front side fin
- 22b, 222b, 322b, 422: Distal end of front side fin
- 23, 223, 323, 423: Back side fin
- 25, 225, 325, 425: Flow channel
- 30: Frame
- 31: First frame part
- 32: Second frame part
- 33: One side wall of frame (second frame part) in fin alignment direction
- 33b: Flat inner surface of one side wall of frame (second frame part) in fin alignment direction
- 421f: One end face in fin alignment direction of Base
- A: Coolant flow direction
- C: Fin extending direction
- D: Fin alignment direction
- P: Interval between front side fins and Interval between back side fins
- H1: Protruding height of front side fin
- H2: Protruding height of back side fin

## Claims

1. A heat exchanger (10; 110; 210; 310; 410) in which a fin member (20; 220; 320; 420) including a plurality of fins forming coolant flow channels (25; 225; 325; 425) is arranged inside a frame (30) forming an outer frame,
wherein the fin member (20; 220; 320; 420) is a fin member integrally formed by extrusion molding, the fin member (20; 220; 320; 420) including:
a rectangular flat plate-like base (21; 221; 321; 421);
a plurality of front side fins (22; 222; 322, 422) protruding from a front side of the base (21; 221; 321; 421) and each having a flat plate shape extending in a fin extending direction (C) along an extrusion direction of the extrusion molding, the front side fins (22; 222, 322, 422) being arranged in a row at intervals in a fin alignment direction (D) orthogonal to the fin extending direction (C); and
a plurality of back side fins (23, 223, 323, 423) protruding from a back side of the base (21; 221; 321; 421) and each having a flat plate shape extending in the fin extending direction (C), the back side fins (23, 223, 323, 423) being arranged in a row at intervals in the fin alignment direction (D),
**characterized in that**
distal ends of at least either the front side fins (22; 222; 322; 422) or the back side fins (23, 223, 323; 423) are welded to the frame (30) while the front side and the back side of the base (21; 221; 321; 421) are not welded to the frame (30).

2. The heat exchanger (110; 210) according to claim 1,
wherein a plurality of fin members (20; 220) having the same shape are arranged with their fin extending directions (C) all coinciding with each other and in a row at intervals in a flow direction (A) of the coolant along the fin extending direction (C),
the fin members (20; 220) have the front side fins (22; 222) and the back side fins (23; 223) arranged at equal and regular intervals in the fin alignment direction (D),
the front side fins (22, 222) of the fin members (20; 220) adjacent to each other in the fin extending direction (C) are arranged offset from each other by just half of the interval in the fin alignment (D), and
the back side fins (23, 223) of the fin members (20; 220) adjacent to each other in the fin extending direction (C) are arranged offset from each other by just half of the interval in the fin alignment direction (D).

3. The exchanger (210) according to claim 1,
wherein a plurality of fin members (220) having the same shape are arranged with their fin extending directions (C) all coinciding with each other and in a row at intervals in a flow direction (A) of the coolant along the fin extending direction (C),
the fin members (220) have the front side fins (222) and the back side fins (223) arranged at equal and regular intervals in the fin alignment direction (D),
the front side fins (222) and the back side fins (223) are arranged offset from each other by just half of the interval in the fin alignment direction (D), and
the plurality of fin members (220) are aligned in the coolant flow direction (A) with the front side and the back side of their bases (221) being oriented alternately oppositely.

4. The heat exchanger (310) according to one of claims 1 to 3,
wherein a plurality of fin members (320) having the same shape are arranged with their fin extending directions (C) all coinciding with each other and in a row at intervals in a flow direction (A) of the coolant along the fin extending direction (C),
the fin members (320) have the plurality of front side fins (322) of the same shape and the plurality of back side fins (323) of the same shape, the front side fins (322) and the back side fins (323) being different in protruding height from each other, and
the plurality of fin members (320) are arranged in the coolant flow direction (A) with the front and back sides of their bases (321) being oriented alternately oppositely.

5. The heat exchanger (10; 110; 410) according to claim 1 or 2,
wherein the fin member (20; 420) has the front side fins (22; 422) and back side fins (23; 423) symmetrical with each other with respect to the base (21; 421)

6. The heat exchanger (410) according to one of claims 1 to 5,
wherein a plurality of fin members (420) having the same shape are arranged with their fin extending directions (C) all coinciding with each other and in a row at intervals in a flow direction (A) of the coolant along the fin extending direction (C),
the fin members (420) have the front side fins (422) and the back side fins (423) protruding obliquely toward the same side in the fin alignment direction, and
the plurality of fin members (420) are arranged relative to each other such that their front side fins (422) and back side fins (423) incline toward the same side, one end faces (421f) of the bases (421) in the fin alignment direction (D) being abutted on a flat inner wall surface (33b) of one side wall (33) of the frame (30) in the fin alignment direction (D).

7. A method of manufacturing a heat exchanger (10; 110; 210; 310; 410) in which a fin member (20; 220; 320; 420) including a plurality of fins forming coolant flow channels (25; 225; 325; 425) is arranged inside a frame (30) forming an outer frame, the method including:
an extrusion molding step of integrally forming the fin member (20; 220; 320; 420) by extrusion molding;
an arranging step of arranging the fin member (20; 220; 320; 420) molded in the extrusion molding step inside the frame (30); and
a joining step of welding the frame (30) and the fin member (20; 220; 320; 420) arranged inside the frame (30),
wherein the extrusion molding step includes integrally forming the fin member (20; 220; 320; 420) by extrusion molding, the fin member (20; 220; 320; 420) including:
a rectangular flat plate-like base (21; 221; 321; 421);
a plurality of front side fins (22; 22; 322; 422) protruding from a front side of the base (21; 221; 321; 421) and having a flat plate shape extending in a fin extending direction (C) along an extrusion direction of the extrusion direction of the extrusion molding, the front side fins (22; 222; 322; 422) being arranged in a row at intervals in a fin alignment direction (D) orthogonal to the fin extending direction (C); and
a plurality of back side fins (23; 223,323, 423) protruding from a back side of the base (21; 221; 321; 421) and having a flat plate shape extending in the fin extending direction along the extrusion direction (C) of the extrusion molding, the back side fins (23; 223; 323; 423) being arranged in a row at intervals in the fin alignment direction (D),
**characterized in that**
the joining step includes welding distal ends of at least either the front side fins (22; 222; 322; 422) or the back side fins (23; 223; 323; 423) to the frame (30) without the front side and the back side of the base (21; 221; 321; 421) to the frame (30).

8. The method of manufacturing a heat exchanger (110; 210) according to claim 7,
wherein the extrusion molding step includes integrally forming the fin member (20; 220) by extrusion molding, the fin member (20; 220) having the front side fins (22; 222) and the back side fins (23; 223) arranged at equal and regular intervals in the fin alignment direction (D), and
the arranging step includes arranging a plurality of fin members (20; 220) having the same shape with their fin extending directions (D) coinciding with each other and in a row at intervals in the coolant flow direction (A) along the fin extending direction (C),
the arranging step including arranging the fin members (20; 220) so that the front side fins (22; 222) of the fin members (20; 220) adjacent to each other in the fin extending direction (C) are offset from each other by just half of the interval in the fin alignment direction (D) and the back side fin (23; 223) of the fin members (20; 220) adjacent to each other in the fin extending direction (C) are offset from each other by just half of the interval in the fin alignment direction (D).

9. The method of manufacturing a heat exchanger (210) according to claim 7,
wherein the extrusion molding step includes integrally forming the fin member (220) by extrusion molding, the fin member (220) having the front side fins (222) and the back side fins (223) arranged at equal and regular intervals in the fin alignment direction (D), the front side fins (222) and the back side fins (223) being arranged offset from each other by just half of the interval in the fin alignment direction (D), and
the arranging step includes arranging a plurality of fin members (220) having the same shape with their fin extending directions (C) coinciding with each other and in a row at intervals in the coolant flow direction (A) along the fin extending direction (C),
the arranging step including aligning the plurality of fin members (220) straight in a row in the coolant flow direction (A), with the front and back sides of their bases (221) being oriented alternately oppositely.

10. The method of manufacturing a heat exchanger (310) according to one of claims 7 to 9,
wherein the extrusion molding step includes integrally forming the fin member (320) by extrusion molding, the fin member (320) having the plurality of front side fins (322) of the same shape and the plurality of back side fins (323) of the same shape, the front side fins (322) and the back side fins (323) being different in protruding height from each other; and
the arranging step includes arranging a plurality of fin members (320) having the same shape with their fin extending directions (C) coinciding with each other and in a row at intervals in the coolant flow direction (A) along the fin extending direction (C),
the arranging step including aligning the plurality of fin members (320) in the coolant flow direction (A) with the front and back sides of their bases (321) being oriented alternately oppositely.

11. The method of manufacturing a heat exchanger (10; 110; 410) according to claim 7 or 8, wherein the extrusion molding step includes integrally forming the fin member (20; 420) by extrusion molding, the fin member (20; 420) having the front side fins (22; 422) and the back side fins (23; 423) symmetrical with each other with respect to the base (21; 421).

12. The method of manufacturing a heat exchanger (410) according to one of claims 7 to 11,
wherein the extrusion molding step includes integrally forming the fin member (420) by extrusion molding, the fin member (420) having the front side fins (422) and the back side fins (423) protruding obliquely toward the same side in the fin alignment direction (D),
the arranging step includes arranging a plurality of fin members (420) having the same shape with their fin extending directions (C) all coinciding with each other and in a row in the coolant flow direction (A) along the fin extending direction (C),
the arranging step including arranging the plurality of fin members (420) inside the frame (30) such that the front side fins (422) and the back side fins (423) of the fin members (420) incline toward the same side, and
the joining step includes welding the frame (30) and the plurality of fin members (420) located inside the frame (30) while pressing the distal ends (422b) of the front side fins (422) toward the front side of the base (421) through the frame (30) and pressing the distal ends (423b) of the back side fins (423) toward the back side of the base (421) through the frame (30), and abutting one end faces (421f) of the bases (421) in the fin alignment direction (D) on a flat inner wall surface (33b) of one side wall (33) of the frame (30) in the fin alignment direction (D).

## Patentansprüche

1. Wärmetauscher (10; 110; 210; 310; 410), in dem ein Rippenelement (20; 220; 320; 420) mit einer Vielzahl von Rippen, die Kühlmittelflusskanäle (25; 225; 325; 425) ausbilden, innerhalb eines Rahmens (30), der einen äußeren Rahmen ausbildet, angeordnet ist,
wobei das Rippenelement (20; 220; 320; 420) ein Rippenelement ist, das einstückig mittels Strangpressens ausgebildet ist, wobei das Rippenelement (20; 220; 320; 420) umfasst:
eine rechteckige flache plattenartige Basis (21 ; 221 ; 321 ; 421);
eine Vielzahl vorderseitiger Rippen (22; 222; 322, 422), die von einer Vorderseite der Basis (21 ; 221 ; 321 ; 421) vorstehen und jeweils eine flache Plattenform haben, die sich in eine Rippenerstreckungsrichtung (C) entlang einer Extrusionsrichtung des Strangpressens erstreckt, wobei die vorderseitigen Rippen (22; 222, 322, 422) in einer Reihe in Intervallen in einer Rippenanordnungsrichtung (D) senkrecht zu der Rippenerstreckungsrichtung (C) angeordnet sind; und
eine Vielzahl rückseitiger Rippen (23, 223, 323, 423), die von einer Rückseite der Basis (21; 221; 321; 421) vorstehen und jeweils eine flache Plattenform haben, die sich in die Rippenerstreckungsrichtung (C) erstreckt, wobei die rückseitigen Rippen (23, 223, 323, 423) in einer Reihe in Intervallen in der Rippenanordnungsrichtung (D) angeordnet sind,
**dadurch gekennzeichnet, dass**
entfernte Enden von zumindest entweder den vorderseitigen Rippen (22; 222; 322; 422) oder den rückseitigen Rippen (23, 223, 323; 423) an den Rahmen (30) geschweißt sind, während die Vorderseite und die Rückseite der Basis (21 ; 221 ; 321 ; 421) nicht an den Rahmen (30) geschweißt sind.

2. Wärmetauscher (110; 210) nach Anspruch 1,
wobei eine Vielzahl von Rippenelementen (20; 220), die die gleiche Form haben, mit ihrer miteinander gänzlich übereinstimmenden Rippenerstreckungsrichtung (C) und in einer Reihe in Intervallen in einer Fließrichtung (A) des Kühlmittels entlang der Rippenerstreckungsrichtung (C) angeordnet sind,
die Rippenelemente (20; 220) die vorderseitigen Rippen (22; 222) und die rückseitigen Rippen (23; 223) in gleichen und regulären Intervallen in der Rippenanordnungsrichtung (D) angeordnet haben,
die vorderseitigen Rippen (22, 222) der Rippenelemente (20; 220), die in der Rippenerstreckungsrichtung (C) zueinander benachbart sind, um lediglich die Hälfte des Intervalls in der Rippenanordnung (D) voneinander versetzt angeordnet sind, und
die rückseitigen Rippen (23, 223) der Rippenelemente (20; 220), die in der Rippenerstreckungsrichtung (C) zueinander benachbart sind, um lediglich die Hälfte des Intervalls in der Rippenanordnungsrichtung (D) voneinander versetzt angeordnet sind.

3. Tauscher (210) nach Anspruch 1,
wobei eine Vielzahl von Rippenelementen (220), die die gleiche Form haben, mit ihrer miteinander gänzlich übereinstimmenden Rippenerstreckungsrichtung (C) und in einer Reihe in Intervallen in einer Fließrichtung (A) des Kühlmittels entlang der Rippenerstreckungsrichtung (C) angeordnet sind,
die Rippenelemente (220) die vorderseitigen Rippen (222) und die rückseitigen Rippen (223) zu gleichen und regulären Intervallen in der Rippenanordnungsrichtung (D) angeordnet haben,
die vorderseitigen Rippen (222) und die rückseitigen Rippen (223) um lediglich die Hälfte des Intervalls in der Rippenanordnungsrichtung (D) voneinander versetzt angeordnet sind, und
die Vielzahl von Rippenelementen (220) in der Kühlmittelfließrichtung (A) mit der Vorderseite und der Rückseite ihrer Basen (221), die abwechselnd gegenseitig orientiert sind, ausgerichtet ist.

4. Wärmetauscher (310) nach einem der Ansprüche 1 bis 3,
wobei eine Vielzahl von Rippenelementen (320), die die gleiche Form haben, mit ihrer miteinander gänzlich übereinstimmenden Rippenerstreckungsrichtung (C) und in einer Reihe in Intervallen in einer Fließrichtung (A) des Kühlmittels entlang der Rippenerstreckungsrichtung (C) angeordnet sind,
die Rippenelemente (320) die Vielzahl von vorderseitigen Rippen (322) der gleichen Form und die Vielzahl von rückseitigen Rippen (323) der gleichen Form haben, wobei die vorderseitigen Rippen (322) und die rückseitigen Rippen (323) bezüglich der vorstehenden Höhe voneinander verschieden sind, und
die Vielzahl von Rippenelementen (320) in der Kühlmittelflussrichtung (A), mit den Vorder- und Rückseiten ihrer Basen (321), die abwechselnd gegenseitig orientiert sind, angeordnet ist.

5. Wärmetauscher (10; 110; 410) nach Anspruch 1 oder 2,
wobei das Rippenelement (20; 420) die vorderseitigen Rippen (22; 422) und die rückseitigen Rippen (23; 423) symmetrisch zueinander bezüglich der Basis (21 ; 421) hat.

6. Wärmetauscher (410) nach einem der Ansprüche 1 bis 5,
wobei eine Vielzahl von Rippenelementen (420), die die gleiche Form haben, mit ihrer miteinander gänzlich übereinstimmenden Rippenerstreckungsrichtung (C) und in einer Reihe in Intervallen in einer Fließrichtung (A) des Kühlmittels entlang der Rippenerstreckungsrichtung (C) angeordnet sind,
die Rippenelemente (420) die vorderseitigen Rippen (422) und die rückseitigen Rippen (423) schräg zu der gleichen Seite in der Rippenanordnungsrichtung vorstehend haben, und
die Vielzahl von Rippenelementen (420) relativ zueinander angeordnet ist, sodass ihre vorderseitigen Rippen (422) und rückseitigen Rippen (423) sich zu der gleichen Seite neigen, wobei Endflächen (421f) der Basen (421) in der Rippenanordnungsrichtung (D) an einer flachen Innenwandoberfläche (33b) einer Seitenwand (33) des Rahmens (30) in der Rippenanordnungsrichtung (D) angestoßen sind.

7. Verfahren zum Herstellen eines Wärmetauschers (10; 110; 210; 310; 410), in dem ein Rippenelement (20; 220; 320; 420), das eine Vielzahl von Rippen umfasst, die Kühlmittelflusskanäle (25; 225; 325; 425) ausbilden, innerhalb eines Rahmens (30), der einen äußeren Rahmen ausbildet, angeordnet ist, wobei das Verfahren umfasst:
einen Strangpressschritt eines einstückigen Ausbildens des Rippenelements (20; 220; 320; 420) mittels Strangpressens;
einen Anordnungsschritt eines Anordnens des Rippenelements (20; 220; 320; 420), das in dem Strangpressschritt geschmolzen wurde, innerhalb des Rahmens (30); und
einen Verbindungsschritt eines Schweißens des Rahmens (30) und des Rippenelements (20; 220; 320; 420), das innerhalb des Rahmens (30) angeordnet ist,
wobei der Strangpressschritt ein einstückiges Ausbilden des Rippenelements (20; 220; 320; 420) mittels Strangpressens umfasst, wobei das Rippenelement (20; 220; 320; 420) umfasst:
eine rechteckige flache plattenartige Basis (21; 221; 321; 421);
eine Vielzahl von vorderseitigen Rippen (22; 222; 322; 422), die von einer Vorderseite der Basis (21 ; 221 ; 321 ; 421) vorstehen und eine flache Plattenform haben, die sich in eine Rippenerstreckungsrichtung (C) entlang einer Extrusionsrichtung der Extrusionsrichtung des Strangpressens erstreckt, wobei die vorderseitigen Rippen (22; 222; 322; 422) in einer Reihe in Intervallen in einer Rippenanordnungsrichtung (D) senkrecht zu der Rippenerstreckungsrichtung (C) angeordnet sind; und
eine Vielzahl von rückseitigen Rippen (23; 223, 323, 423), die sich von einer Rückseite der Basis (21 ; 221 ; 321 ; 421) erstrecken und eine flache Plattenform haben, die sich in der Rippenerstreckungsrichtung entlang der Extrusionsrichtung (C) des Strangpressens erstreckt, wobei die rückseitigen Rippen (23; 223; 323; 423) in einer Reihe in Intervallen in der Rippenanordnungsrichtung (D) angeordnet sind,
**dadurch gekennzeichnet, dass**
der Verbindungsschritt ein Schweißen entfernter Enden von zumindest entweder den vorderseitigen Rippen (22; 222; 322; 422) oder den rückseitigen Rippen (23; 223; 323; 423) an den Rahmen (30), ohne die Vorderseite und die Rückseite der Basis (21; 221; 321; 412) an den Rahmen (30), umfasst.

8. Verfahren zum Herstellen eines Wärmetauschers (110; 210) nach Anspruch 7,
wobei der Strangpressschritt ein einstückiges Ausbilden des Rippenelements (20; 220) mittels Strangpressens umfasst, wobei das Rippenelement (20; 220) die vorderseitigen Rippen (22; 222) und die rückseitigen Rippen (23; 223) zu gleichen und regulären Intervallen in der Rippenanordnungsrichtung (D) angeordnet hat, und
der Anordnungsschritt ein Anordnen einer Vielzahl von Rippenelementen (20; 220), die die gleiche Form haben, mit ihrer miteinander übereinstimmenden Rippenerstreckungsrichtung (D) und in einer Reihe in Intervallen in der Kühlmittelflussrichtung (A) entlang der Rippenerstreckungsrichtung (C) umfasst,
der Anordnungsschritt ein Anordnen der Rippenelemente (20; 220) umfasst, sodass die vorderseitigen Rippen (22; 222) der Rippenelemente (20; 220), die in der Rippenerstreckungsrichtung (C) zueinander benachbart sind, um lediglich die Hälfte des Intervalls in der Rippenanordnungsrichtung (D) voneinander versetzt sind und die rückseitige Rippe (23; 223) der Rippenelemente (20; 220), die in der Rippenerstreckungsrichtung (C) zueinander benachbart sind, um lediglich die Hälfte des Intervalls in der Rippenanordnungsrichtung (D) voneinander versetzt sind.

9. Verfahren zum Herstellen eines Wärmetauschers (210) nach Anspruch 7,
wobei der Strangpressschritt ein einstückiges Ausbilden des Rippenelements (220) mittels Strangpressens umfasst, wobei das Rippenelement (220) die vorderseitigen Rippen (222) und die rückseitigen Rippen (223) in gleichen und regulären Intervallen in der Rippenanordnungsrichtung (D) angeordnet hat, wobei die vorderseitigen Rippen (222) und die rückseitigen Rippen (223) um lediglich die Hälfte des Intervalls in der Rippenanordnungsrichtung (D) voneinander versetzt angeordnet sind, und
der Anordnungsschritt ein Anordnen einer Vielzahl von Rippenelementen (220), die dieselbe Form haben, mit ihrer miteinander übereinstimmenden Rippenerstreckungsrichtung (C) und in einer Reihe zu Intervallen in der Kühlmittelflussrichtung (A) entlang der Rippenerstreckungsrichtung (C) umfasst,
der Anordnungsschritt ein Ausrichten der Vielzahl von Rippenelementen (220) gerade in einer Reihe in der Kühlmittelflussrichtung (A) mit den abwechselnd gegenseitig orientierten Vorder- und Rückseiten ihrer Basen (221) umfasst.

10. Verfahren zum Herstellen eines Wärmetauschers (310) nach einem der Ansprüche 7 bis 9,
wobei der Strangpressschritt ein einstückiges Ausbilden des Rippenelements (320) mittels Strangpressens umfasst, wobei das Rippenelement (320) eine Vielzahl von vorderseitigen Rippen (322) der gleichen Form und eine Vielzahl von rückseitigen Rippen (323) der gleichen Form hat, wobei die vorderseitigen Rippen (322) und die rückseitigen Rippen (323) bezüglich der Vorstehhöhe voneinander verschieden sind; und
der Anordnungsschritt ein Anordnen einer Vielzahl von Rippenelementen (320), die die gleiche Form haben, mit ihrer miteinander übereinstimmenden Rippenerstreckungsrichtung (C) und in einer Reihe in Intervallen in der Kühlmittelflussrichtung (A) entlang der Rippenerstreckungsrichtung (C) umfasst,
der Anordnungsschritt ein Ausrichten der Vielzahl von Rippenelementen (320) in der Kühlmittelflussrichtung (A) mit den Vorder- und Rückseiten ihrer Basen (321), die abwechselnd gegenseitig orientiert sind, umfasst.

11. Verfahren zum Herstellen eines Wärmetauschers (10; 110; 410) nach Anspruch 7 oder 8, wobei der Strangpressschritt ein einstückiges Ausbilden des Rippenelements (20; 420) mittels Strangpressens umfasst, wobei das Rippenelement (20; 420) die vorderseitigen Rippen (22; 422) und die rückseitigen Rippen (23; 423) symmetrisch zueinander bezüglich der Basis (21 ; 421) hat.

12. Verfahren zum Herstellen eines Wärmetauschers (410) nach einem der Ansprüche 7 bis 11,
wobei der Strangpressschritt ein einstückiges Ausbilden des Rippenelements (420) mittels Strangpressens umfasst, wobei das Rippenelement (420) die vorderseitigen Rippen (422) und die rückseitigen Rippen (423) schräg zu der gleichen Seite in der Rippenanordnungsrichtung (D) vorstehend hat,
der Anordnungsschritt ein Anordnen einer Vielzahl von Rippenelementen (420), die die gleiche Form haben, mit ihrer miteinander übereinstimmenden Rippenerstreckungsrichtungen (C) hat, und in einer Reihe in der Kühlmittelflussrichtung (A) entlang der Rippenerstreckungsrichtung (C) umfasst,
der Anordnungsschritt ein Anordnen der Vielzahl von Rippenelementen (420) innerhalb des Rahmens (30) umfasst, sodass die vorderseitigen Rippen (422) und die rückseitigen Rippen (423) der Rippenelemente (420) sich zu der gleichen Seite neigen, und
der Verbindungsschritt ein Schweißen des Rahmens (30) und der Vielzahl von Rippenelementen (420), die innerhalb des Rahmens (30) gelegen sind, umfasst, während eines Drückens der entfernten Enden (422b) der vorderseitigen Rippen (422) zu der Vorderseite der Basis (421) durch den Rahmen (30) und eines Drückens der entfernten Enden (423b) der rückseitigen Rippen (423) zu der Rückseite der Basis (421) durch den Rahmen (30), sowie eines Anstoßens von Endflächen (421f) der Basen (421) in der Rippenanordnungsrichtung (D) auf einer flachen inneren Wandoberfläche (33b) einer Seitenwand (33) des Rahmens (30) in der Rippenanordnungsrichtung (D).

## Revendications

1. Échangeur thermique (10 ; 110 ; 210 ; 310 ; 410) dans lequel un organe d'ailettes (20 ; 220 ; 320 ; 420) comportant une pluralité d'ailettes formant des canaux d'écoulement de réfrigérant (25 ; 225 ; 325 ; 425) est disposé à l'intérieur d'un cadre (30) formant un cadre extérieur,
l'organe d'ailettes (20 ; 220 ; 320 ; 420) étant un organe d'ailettes formé intégralement par moulage par extrusion, l'organe d'ailettes (20 ; 220 ; 320 ; 420) comportant :
une base de type plaque plane rectangulaire (21 ; 221 ; 321 ; 421) ;
une pluralité d'ailettes du côté avant (22 ; 222 ; 322 ; 422) faisant saillie depuis un côté avant de la base (21 ; 221 ; 321 ; 421) et ayant chacune une forme de plaque plane s'étendant dans une direction d'étendue d'ailette (C) le long d'une direction d'extrusion de moulage par extrusion, les ailettes du côté avant (22 ; 222 ; 322 ; 422) étant agencées en une rangée à intervalles dans une direction d'alignement d'ailettes (D) perpendiculaire à la direction d'étendue d'ailette (C) ; et
une pluralité d'ailettes du côté arrière (23 ; 223 ; 323 ; 423) faisant saillie depuis un côté arrière de la base (21 ; 221 ; 321 ; 421) et ayant chacune une forme de plaque plane s'étendant dans une direction d'étendue d'ailette (C), les ailettes du côté arrière (23 ; 223 ; 323 ; 423) étant agencées en une rangée à intervalles dans la direction d'alignement d'ailettes (D),
**caractérisé en ce que**
des extrémités distales d'au moins soit les ailettes du côté avant (22 ; 222 ; 322 ; 422) soit les ailettes du côté arrière (23 ; 223 ; 323 ; 423) sont soudées au cadre (30) tandis que le côté avant et le côté arrière de la base (21 ; 221 ; 321 ; 421) ne sont pas soudés au cadre (30).

2. Échangeur thermique (110 ; 210) selon la revendication 1,
dans lequel une pluralité d'organes d'ailettes (20 ; 220) de même forme sont agencés de manière à ce que leurs directions d'étendue d'ailette (C) coïncident toutes les unes avec les autres et en une rangée à intervalles dans une direction d'écoulement (A) du réfrigérant le long de la direction d'étendue d'ailette (C),
les organes d'ailettes (20 ; 220) ont les ailettes du côté avant (22 ; 222) et les ailettes du côté arrière (23 ; 223) agencées à intervalles égaux et réguliers dans la direction d'alignement d'ailettes (D),
les ailettes du côté avant (22 ; 222) des organes d'ailettes (20 ; 220) adjacents les uns aux autres dans la direction d'étendue d'ailette (C) sont agencées de manière décalée les unes des autres de seulement la moitié de l'intervalle dans la direction d'alignement d'ailettes (D), et
les ailettes du côté arrière (23 ; 223) des organes d'ailettes (20 ; 220) adjacents les uns aux autres dans la direction d'étendue d'ailette (C) sont agencées de manière décalée les unes des autres de seulement la moitié de l'intervalle dans la direction d'alignement d'ailettes (D).

3. Echangeur thermique (210) selon la revendication 1,
dans lequel une pluralité d'organes d'ailettes (220) ayant la même forme sont agencés de manière à ce que leurs directions d'étendue d'ailette (C) coïncident toutes les unes avec les autres et en une rangée à intervalles dans une direction d'écoulement (A) du réfrigérant le long de la direction d'étendue d'ailette (C),
les organes d'ailettes (220) ont les ailettes du côté avant (222) et les ailettes du côté arrière (223) agencées à intervalles égaux et réguliers dans la direction d'alignement d'ailettes (D),
les ailettes du côté avant (222) et les ailettes du côté arrière (223) sont agencées de manière décalée les unes des autres de seulement la moitié de l'intervalle dans la direction d'alignement d'ailettes (D), et
la pluralité d'organes d'ailettes (220) sont alignés dans la direction d'écoulement (A) du réfrigérant avec le côté avant et le côté arrière de leurs bases (221) orientés en alternance de manière opposée.

4. Echangeur thermique (310) selon l'une quelconque des revendications 1 à 3,
dans lequel une pluralité d'organes d'ailettes (320) ayant la même forme sont agencés de manière à ce que leurs directions d'étendue d'ailette (C) coïncident toutes les unes avec les autres et en une rangée à intervalles dans une direction d'écoulement (A) du réfrigérant le long de la direction d'étendue d'ailette (C),
les organes d'ailettes (320) ont la pluralité d'ailettes du côté avant (322) de même forme et la pluralité d'ailettes du côté arrière (323) de même forme, les ailettes du côté avant (322) et les ailettes du côté arrière (323) étant différentes les unes des autres en termes de hauteur d'extension, et
la pluralité d'organes d'ailettes (320) sont agencés dans la direction d'écoulement (A) du réfrigérant avec le côté avant et le côté arrière de leurs bases (321) orientés en alternance de manière opposée.

5. Echangeur thermique (10 ; 110 ; 410) selon la revendication 1 ou 2,
dans lequel l'organe d'ailettes (20 ; 420) a les ailettes du côté avant (22 ; 422) et les ailettes du côté arrière (23 ; 423) symétriques les unes par rapport aux autres par rapport à la base (21 ; 421).

6. Echangeur thermique (410) selon l'une quelconque des revendications 1 à 5,
dans lequel une pluralité d'organes d'ailettes (420) de même forme sont agencés de manière à ce que leurs directions d'étendue d'ailette (C) coïncident toutes les unes avec les autres et en une rangée à intervalles dans une direction d'écoulement (A) du réfrigérant le long de la direction d'étendue d'ailette (C),
les organes d'ailettes (420) ont les ailettes du côté avant (422) et les ailettes du côté arrière (423) faisant saillie obliquement vers le même côté dans la direction d'alignement d'ailettes, et la pluralité d'organes d'ailettes (420) sont agencés les uns par rapport aux autres de telle sorte que leurs ailettes du côté avant (422) et leurs ailettes du côté arrière (423) soient inclinées vers le même côté, une face d'extrémité (421f) des bases (421) dans la direction d'alignement d'ailettes (D) étant en butée sur une surface de paroi interne plane (33b) d'une paroi latérale (33) du cadre (30) dans la direction d'alignement d'ailettes (D).

7. Procédé de fabrication d'un échangeur thermique (10 ; 110 ; 210 ; 310 ; 410) dans lequel un organe d'ailettes (20 ; 220 ; 320 ; 420) comportant une pluralité d'ailettes formant des canaux d'écoulement de réfrigérant (25 ; 225 ; 325 ; 425) est disposé à l'intérieur d'un cadre (30) formant un cadre extérieur, le procédé comportant :
une étape de moulage par extrusion, pour former intégralement l'organe d'ailettes (20 ; 220 ; 320 ; 420) par moulage par extrusion ;
une étape d'agencement pour agencer l'organe d'ailettes (20 ; 220 ; 320 ; 420) moulé dans l'étape de moulage par extrusion à l'intérieur du cadre (30) ; et
une étape d'assemblage pour souder le cadre (30) et l'organe d'ailettes (20 ; 220 ; 320 ; 420) agencé à l'intérieur du cadre (30),
l'étape de moulage par extrusion comportant la formation intégrale de l'organe d'ailettes (20 ; 220 ; 320 ; 420) par moulage par extrusion, l'organe d'ailettes (20 ; 220 ; 320 ; 420) comportant :
une base de type plaque plane rectangulaire (21 ; 221 ; 321 ; 421) ;
une pluralité d'ailettes du côté avant (22 ; 222 ; 322, 422) faisant saillie depuis un côté avant de la base (21 ; 221 ; 321 ; 421) et ayant une forme de plaque plane s'étendant dans une direction d'étendue d'ailette (C) le long d'une direction d'extrusion de moulage par extrusion, les ailettes du côté avant (22 ; 222 ; 322, 422) étant agencées en une rangée à intervalles dans une direction d'alignement d'ailettes (D) perpendiculaire à la direction d'étendue d'ailette (C) ; et
une pluralité d'ailettes du côté arrière (23, 223, 323, 423) faisant saillie depuis un côté arrière de la base (21 ; 221 ; 321 ; 421) et ayant une forme de plaque plane s'étendant dans la direction d'étendue d'ailette (C) le long de la direction d'extrusion du moulage par extrusion, les ailettes du côté arrière (23 ; 223 ; 323 ; 423) étant agencées en une rangée à intervalles dans la direction d'alignement d'ailettes (D),
**caractérisé en ce que**
l'étape d'assemblage comporte le soudage d'extrémités distales d'au moins soit les ailettes du côté avant (22 ; 222 ; 322 ; 422) soit les ailettes du côté arrière (23 ; 223 ; 323 ; 423) au cadre (30) sans souder le côté avant et le côté arrière de la base (21 ; 221 ; 321 ; 421) au cadre (30).

8. Procédé de fabrication d'un échangeur thermique (110 ; 210) selon la revendication 7,
dans lequel l'étape de moulage par extrusion comporte la formation intégrale de l'organe d'ailettes (20 ; 220) par moulage par extrusion, l'organe d'ailettes (20 ; 220) ayant les ailettes du côté avant (22 ; 222) et les ailettes du côté arrière (23 ; 223) agencées à intervalles égaux et réguliers dans la direction d'alignement d'ailettes (D), et
l'étape d'agencement comporte l'agencement d'une pluralité d'organes d'ailettes (20 ; 220) de même forme de manière à ce que leurs directions d'étendue d'ailette (C) coïncident les unes avec les autres et en une rangée à intervalles dans une direction d'écoulement (A) du réfrigérant le long de la direction d'étendue d'ailette (C),
l'étape d'agencement comportant l'agencement des organes d'ailettes (20 ; 220) de telle sorte que les ailettes du côté avant (22 ; 222) des organes d'ailettes (20 ; 220) adjacents les uns aux autres dans la direction d'étendue d'ailette (C) soient décalées les unes des autres de seulement la moitié de l'intervalle dans la direction d'alignement d'ailettes (D), et que les ailettes du côté arrière (23 ; 223) des organes d'ailettes (20 ; 220) adjacents les uns aux autres dans la direction d'étendue d'ailette (C) soient décalées les unes des autres de seulement la moitié de l'intervalle dans la direction d'alignement d'ailettes (D).

9. Procédé de fabrication d'un échangeur thermique (210) selon la revendication 7,
dans lequel l'étape de moulage par extrusion comporte la formation intégrale de l'organe d'ailettes (220) par moulage par extrusion, l'organe d'ailettes (220) ayant les ailettes du côté avant (222) et les ailettes du côté arrière (223) agencées à intervalles égaux et réguliers dans la direction d'alignement d'ailettes (D), les ailettes du côté avant (222) et les ailettes du côté arrière (223) étant agencées de manière décalée les unes des autres de seulement la moitié de l'intervalle dans la direction d'alignement d'ailettes (D), et
l'étape d'agencement comporte l'agencement d'une pluralité d'organes d'ailettes (220) de même forme de manière à ce que leurs directions d'étendue d'ailette (C) coïncident les unes avec les autres et en une rangée à intervalles dans une direction d'écoulement (A) du réfrigérant le long de la direction d'étendue d'ailette (C),
l'étape d'agencement comportant l'alignement de la pluralité d'organes d'ailettes (220) en ligne droite en une rangée dans la direction d'écoulement (A) du réfrigérant, les côtés avant et arrière de leurs bases (221) étant orientés en alternance de manière opposée.

10. Procédé de fabrication d'un échangeur thermique (310) selon l'une quelconque des revendications 7 à 9,
dans lequel l'étape de moulage par extrusion comporte la formation intégrale de l'organe d'ailettes (320) par moulage par extrusion, l'organe d'ailettes (320) ayant la pluralité d'ailettes du côté avant (322) de même forme et la pluralité d'ailettes du côté arrière (323) de même forme, les ailettes du côté avant (322) et les ailettes du côté arrière (323) étant différentes les unes des autres en termes de hauteur d'extension, et
l'étape d'agencement comporte l'agencement d'une pluralité d'organes d'ailettes (320) de même forme de manière à ce que leurs directions d'étendue d'ailette (C) coïncident les unes avec les autres et en une rangée à intervalles dans une direction d'écoulement (A) du réfrigérant le long de la direction d'étendue d'ailette (C),
l'étape d'agencement comportant l'alignement de la pluralité d'organes d'ailettes (320) dans la direction d'écoulement (A) du réfrigérant avec les côtés avant et arrière de leurs bases (321) orientés en alternance de manière opposée.

11. Procédé de fabrication d'un échangeur thermique (10 ; 110 ; 410) selon la revendication 7 ou 8, dans lequel l'étape de moulage par extrusion comporte la formation intégrale de l'organe d'ailettes (20 ; 420) par moulage par extrusion, l'organe d'ailettes (20 ; 420) ayant les ailettes du côté avant (22 ; 422) et les ailettes du côté arrière (23 ; 423) symétriques les unes par rapport aux autres par rapport à la base (21 ; 421).

12. Procédé de fabrication d'un échangeur thermique (410) selon l'une quelconque des revendications 7 à 11,
dans lequel l'étape de moulage par extrusion comporte la formation intégrale de l'organe d'ailettes (420) par moulage par extrusion, l'organe d'ailettes (420) ayant les ailettes du côté avant (422) et les ailettes du côté arrière (423) faisant saillie obliquement vers le même côté dans la direction d'alignement d'ailettes (D),
l'étape d'agencement comporte l'agencement d'une pluralité d'organes d'ailettes (420) de même forme de manière à ce que leurs directions d'étendue d'ailette (C) coïncident toutes les unes avec les autres et en une rangée dans une direction d'écoulement (A) du réfrigérant le long de la direction d'étendue d'ailette (C),
l'étape d'agencement comportant l'agencement de la pluralité d'organes d'ailettes (420) à l'intérieur du cadre (30) de telle sorte que les ailettes du côté avant (422) et les ailettes du côté arrière (423) des organes d'ailettes (420) soient inclinées vers le même côté, et
l'étape d'assemblage comporte le soudage du cadre (30) et de la pluralité d'organes d'ailettes (420) situés à l'intérieur du cadre (30) tout en pressant les extrémités distales (422b) des ailettes du côté avant (422) vers le côté avant de la base (421) à travers le cadre (30) et en pressant les extrémités distales (423b) des ailettes du côté arrière (423) vers le côté arrière de la base (421) à travers le cadre (30), et la mise en butée d'une face d'extrémité (421f) des bases (421) dans la direction d'alignement d'ailettes (D) sur une surface de paroi interne plane (33b) d'une paroi latérale (33) du cadre (30) dans la direction d'alignement d'ailettes (D).
